# EUROPEAN PATENT SPECIFICATION

(11) **EP 2 513 722 B1**
(45) Date of publication and mention of the grant of the patent: **25.01.2017**
(21) Application number: 10795586.6
(22) Date of filing: 16.12.2010
(51) Int. Cl.: G03F 7/00, G03F 7/027, G03F 7/004, G03F 7/029, G03F 7/038, B29C 67/00

(54) **LED CURABLE LIQUID RESIN COMPOSITIONS FOR ADDITIVE FABRICATION, PROCESS FOR MAKING A THREE-DIMENSIONAL OBJECT USING THE SAME**
LED-HÄRTBARE FLÜSSIGE HARZZUSAMMENSETZUNGEN FÜR ADDITIVE FABRICATION SOWIE VERFAHREN DAMIT
COMPOSITIONS DE RÉSINE LIQUIDE DURCISSABLES AU MOYEN D'UNE DEL POUR FABRICATION PAR ADDITION, PROCÉDÉ POUR FABRIQUER UN OBJET 3D L'UTILISANT

(30) Priority: 17.12.2009 US 287620 P
(43) Date of publication of application: 24.10.2012
(73) Proprietor: DSM IP Assets B.V., 6411 TE Heerlen (NL)
(72) Inventor: DAKE, Ken, South Elgin, IL 60177 (US); XU, Jigeng, South Elgin, IL 60177-3264 (US); BISHOP, Timothy, Algonquin, IL 60102 (US)
(74) Representative: V.O.
(86) International application number: PCT/US2010/060677
(87) International publication number: WO 2011/075555

(56) References cited:
- EP-A1- 1 591 470
- WO-A1-2007/118794
- WO-A1-2007/124911
- WO-A1-2008/049743
- WO-A1-2009/101758
- US-A- 5 468 902

## Description

### FIELD OF THE INVENTION

The present invention relates to photocurable resin compositions used in additive fabrication applications.

### BACKGROUND OF THE INVENTION

Additive fabrication processes for producing three dimensional articles are known in the field. Additive fabrication processes utilize computer-aided design (CAD) data of an object to build three-dimensional parts layer-by-layer. These three-dimensional parts may be formed from liquid resins, powders, or other materials.

A non-limiting example of an additive fabrication process is stereolithography (SL). Stereolithography is a well-known process for rapidly producing models, prototypes, patterns, and production parts in certain applications. SL uses CAD data of an object wherein the data is transformed into thin cross-sections of a three-dimensional object. The data is loaded into a computer which controls a laser beam that traces the pattern of a cross section through a liquid radiation curable resin composition contained in a vat, solidifying a thin layer of the resin corresponding to the cross section. The solidified layer is recoated with resin and the laser beam traces another cross section to harden another layer of resin on top of the previous layer. The process is repeated layer by layer until the three-dimensional object is completed. When initially formed, the three-dimensional object is, in general, not fully cured and therefore may be subjected to post-curing, if required. An example of an SL process is described in U.S. Patent No. 4,575,330.

There are several types of lasers used in stereolithography, ranging from 193 nm to 355 nm in wavelength. The use of bulky and expensive gas lasers to cure liquid radiation curable resins is well known. The delivery of laser energy in a stereolithography system can be Continuous Wave (CW) or Q-switched pulses. CW lasers provide continuous laser energy and can be used in a high speed scanning process. However, their output power is limited which reduces the amount of curing that occurs during object creation. As a result the finished object will need additional post process curing. In addition, excess heat could be generated at the point of irradiation which may be detrimental to the resin. Further, the use of a laser requires scanning point by point on the resin which can be time-consuming.

Light emitting diodes (LEDs) are semiconductor devices which utilize the phenomenon of electroluminescence to generate light. LEDs consist of a semiconducting material doped with impurities to create a p-n junction capable of emitting light as positive holes join with negative electrons when voltage is applied. The wavelength of emitted light is determined by the materials used in the active region of the semiconductor. Typical materials used in semiconductors of LEDs include, for example, elements from Groups 13 (III) and 15 (V) of the periodic table. These semiconductors are referred to as III-V semiconductors and include, for example, GaAs, GaP, GaAsP, AlGaAs, InGaAsP, AlGaInP, and InGaN semiconductors. Other examples of semiconductors used in LEDs include compounds from Group 14 (IV-IV semiconductor) and Group 12-16 (II-VI). The choice of materials is based on multiple factors including desired wavelength of emission, performance parameters, and cost.

Early LEDs used gallium arsenide (GaAs) to emit infrared (IR) radiation and low intensity red light. Advances in materials science have led to the development of LEDs capable of emitting light with higher intensity and shorter wavelengths, including other colors of visible light and UV light. It is possible to create LEDs that emit light across a wide wavelength spectrum, for example, from a low of about 100 nm to a high of about 900 nm. Typically, LED UV light sources currently emit light at wavelengths between 300 and 475 nm, with 365 nm, 390 nm, and 395 nm being common peak spectral outputs. See textbook,"Light-Emitting Diodes" by E. Fred Schubert, 2^{nd} Edition, © E. Fred Schubert 2006, published by Cambridge University Press.

Several manufacturers offer LED lamps for commercial curing applications. For example, Phoseon Technology, Summit UV, Honle UV America, Inc., IST Metz GmbH, Jenton International Ltd., Lumos Solutions Ltd., Solid UV Inc., Seoul Optodevice Co., Ltd., Spectronics Corporation, Luminus Devices Inc., and Clearstone Technologies, are some of the manufacturers offering LED lamps for curing ink-jet printing compositions, PVC floor coating compositions, metal coating compositions, plastic coating composition, and adhesive compositions.

LED curing devices are used in dental work. An example of such a device is the ELIPAR™ FreeLight 2 LED curing light from 3M ESPE. This device emits light in the visible region with a peak irradiance at 460 nm. LED equipment is also being tested for use in the ink-jet printing, including, for example, by IST Metz.

Although LED lamps are available, photocurable compositions suitable for additive fabrication and curable by the use of LED light are not well known commercially. For example, US Patent 7,211,368 reportedly discloses a liquid stereolithography resin comprising a first urethane acrylate oligomer, a first acrylate monomer, a polymerization modifier, a second urethane acrylate oligomer different from the first urethane acrylate oligomer, and a stabilizer. The first urethane acrylate oligomer is an aliphatic polyester urethane diacrylate oligomer, the first acrylate monomer is ethoxylated (3) trimethylolpropane acrylate, and the polymerization modifier is selected from the group consisting of isobornyl acrylate, ethoxylated (5) pentaerythritol tetraacrylate, an aliphatic urethane acrylate, tris-(2-hydroxyethyl)isocyanurate triacrylate, and mixtures thereof. The resin includes 5-35 weight % of an aliphatic polyester urethane diacrylate oligomer and 0.5-25 weight % ethoxylated (3) trimethylolpropane acrylate, wherein the resin includes 15-45 weight % ethoxylated (5) pentaerythritol tetraacrylate. However, the '368 patent indicates that a laser is used to cure the resin. Further, the '368 patent fails to disclose the use of an acid generating photoinitiator, such as a cationic photoinitiator.

More recently, some attention has been given to the use of LEDs in additive fabrication processes. U.S. Patent No. 6,927,018 and U.S. Patent Application Publication No. 2005/0227186 purportedly provide a method, article of manufacture and system for fabricating an article using photo-activatable building material. The method according to the '018 patent and the '186 publication includes the steps of applying a layer of the photo-activatable building material to a preselected surface, scanning the layer using a plurality of light-emitting centers to photo-activate the layer of photo-activatable building material in accordance with a predetermined photo-initiation process to obtain polymerization of the building material. Scanning is accomplished at a predetermined distance using a predetermined light intensity, and repeating the steps of applying the layer. Each layer is applied to an immediately previous layer, and the layer is scanned with the plurality of light-emitting centers to polymerize the building material until the article is fabricated. While the '018 patent and the '186 publication mention UV LEDs and laser diodes as suitable light-emitting centers, they fail to disclose detailed information on photo-activatable building material suitable for LED cure.

U.S. Patent No. 7,270,528 purportedly discloses a flash curing system for solid freeform fabrication which generates a plurality of radiation emitting pulses that forms a planar flash. The planar flash initiates curing of a curable material dispensed by a solid freeform fabrication apparatus. The '528 patent, while mentioning UV light-emitting diodes (LED) lamps in the specification, sets forth examples where a flash lamp is used to cure the resin composition. The resin composition illustrated in the '528 patent does contain a cationically curable monomer or a cationic photoinitiator.

U.S. Patent Application Publication No. 2008/0231731 or 2008/0169589 or European Patent Application No. EP 1950032 purportedly discloses a solid imaging apparatus that includes a replaceable cartridge containing a source of build material and an extendable and retractable flexible transport film for transporting the build material layer-by-layer from the cartridge to the surface of a build in an image plane. If desired, the apparatus can produce a fully reacted build. A high intensity UV source is said to cure the build between layers. The above publications state that the solid imaging radiation that is used to cure the build material can be "any actinic radiation which causes a photocurable liquid to react to produce a solid, whether a visible or UV source or other source,"

International Patent Publication No. WO 2008/118263 is directed to a system for building a three-dimensional object based on build data representing the three-dimensional object, wherein the system includes an extrusion head that deposits a radiation-curable material in consecutive layers at a high deposition rate. The radiation-curable material of each of the consecutive layers is cooled to a self-supporting state. The system is said to include a radiation source that selectively exposes portions of the consecutive layers to radiation at a high resolution in accordance with the build data. It is stated that the exposure head includes a linear array of high resolution, UV light-emitting diodes (LEDs). P71-1464 CUREBAR™ and P150-3072 PRINTHEAD™ are described as examples of suitable UV-radiation sources for the exposure head. The '263 publication fails to describe exemplary photocurable formulations suitable for curing by LED light in an additive fabrication process.

International Patent Publication No. WO 2005/103121, entitled "Method for photocuring of Resin Compositions", assigned to DSM IP Assets B.V., describes and claims Methods for Light Emitting Diode (LED) curing of a curable resin composition containing a photoinitiating system, characterized in that the highest wavelength at which absorption maximum of the photoinitiating system occurs (λ_{Max PIS}) is at least 20 nm below, and at most 100 nm below, the wavelength at which the emission maximum of the LED occurs (λ_{LED}). The invention in this PCT patent application relates to the use of LED curing in structural applications, in particular in applications for the lining or relining of objects, and to objects containing a cured resin composition obtained by LED curing. This invention provides a simple, environmentally safe and readily controllable method for (re)lining pipes, tanks and vessels, especially for such pipes and equipment having a large diameter, in particular more than 15 cm. The specification does not describe LED radiation curable photocurable resins.

U.S. Patent Application Publication No. 2007/0205528 reportedly discloses an optical molding process wherein the radiation source used is a non-coherent source of radiation. The '528 publication indicates that the photocurable compositions are formulated so as to enable the production of three-dimensional articles having better performance when irradiated with conventional (non-coherent) UV rather than with Laser UV, and states that the photocurable compositions disclosed are more appropriate for UV non-coherent irradiation than for Laser UV. While the '528 publication mentions that "the exposure system uses irradiation from non-coherent light sources, e.g., a xenon fusion lamp, or light emitting diode bars," the exemplified exposure was reportedly carried out according to the method of WO 00/21735, which is said to describe an apparatus and a method wherein the photosensitive material is exposed to a light source illuminating a cross-section of a material by at least two modulator arrangements of individually controllable light modulators.

U.S. Patent Application Publication No. 2009/0267269A or WO 2009/132245 reportedly discloses a continuous-wave (CW) ultraviolet (UV) curing system for solid freeform fabrication (SFF), wherein the curing system is configured to provide an exposure of UV radiation for one or more layers of UV-curable material. It is reported that one or more UV exposures may initiate curing of a curable material in the layer dispensed by a solid freeform fabrication apparatus. According to the '269 or '245 publication, one approach to provide the single or multiple UV exposures is the use of one or more UV LEDs, which generate UV radiation without generating any substantial amounts of infrared (IR) radiation at the same time.

WO-A-2007/124911 discloses a radiation curable composition for the production of three-dimensional shaped articles by means of layerwise imaging methods, wherein the composition comprises a cationically polymerisable component, a cationic photoinitiator, a hydroxy component and an impact modifier.

The foregoing shows that there is an unmet need to provide photocurable resin compositions for additive fabrication which are capable of curing by irradiation by LED light.

### BRIEF SUMMARY OF THE INVENTION

The invention provides a photocurable resin composition for additive fabrication comprising a polymerizable component that is polymerizable by free-radical polymerization, by cationic polymerization, or by both free-radical polymerization and cationic polymerization, and a photoinitiating system capable of initiating the free-radical polymerization, cationic polymerization, or both free-radical polymerization and cationic polymerization,
wherein the photocurable resin composition is a liquid at 25 °C, and is capable of curing to provide a solid upon irradiation with light emitted from a light emitting diode (LED), wherein
the light has a wavelength of from 100 nm to 900 nm, and
wherein the liquid photocurable resin composition has a Critical Exposure (Ec) and a Depth of Penetration(Dp) as measured on a layer of the photocurable resin composition as the composition is curing and calculated as described herein, wherein Ec is from 0.01 seconds to 6.0 seconds and Dp is from 0.03 mm to 0.2 mm (1 to 8 mils). The invention also provides a process of making a three-dimensional object.

In an embodiment, the ratio by weight of cationic photoinitiator to free-radical photoinitiator is less than about 4.0.

In another embodiment, the ratio by weight of cationic polymerizable component to free-radical polymerizable component is less than about 7.0.

In a further aspect, the invention provides a process for making a three-dimensional
article comprising the steps of: forming and selectively curing a layer of a photocurable resin composition by irradiation with a light emitting diode (LED) light having a wavelength from 100 nm to 900 nm, the photocurable resin composition comprising: a polymerizable component that is polymerizable by free-radical polymerization, cationic polymerization, or both free-radical polymerization and cationic polymerization, and a photoinitiating system capable of initiating the free-radical polymerization, cationic polymerization, or both free-radical polymerization and cationic polymerization; wherein the photocurable resin composition is a liquid at about 25 °C, and is capable of curing to provide a solid upon exposure to a light emitting diode (LED) light having a wavelength of from 100 nm to 900 nm, and wherein the liquid photocurable resin composition has a Critical Exposure (Ec) and a Depth of Penetration (Dp) as measured on a layer of the photocurable resin composition as the composition is curing and calculated as described herein, wherein Ec is from 0.01 seconds to 6.0 seconds and Dp is from 0.03 mm to 0.2 mm (1 to 8 mils); and repeating the steps of forming and selectively curing a layer of the photocurable resin composition a plurality of times to obtain the three-dimensional article.

### DETAILED DESCRIPTION OF THE INVENTION

The present invention provides a LED photocurable resin composition for additive fabrication comprising a polymerizable component that is polymerizable by at least one of a free-radically initiated polymerization and a cationically initiated polymerization, and a photoinitiating system capable of initiating the polymerization of a free-radically polymerizable component and/or the cationically polymerizable component. The photocurable resin composition for additive fabrication of the invention is characterized by one or more advantages, for example, rapid cure and improved mechanical properties of the resulting cured resin and the three-dimensional article.

In accordance with an embodiment, the photocurable resin composition is a liquid at about 25 °C, and is capable of curing to provide a solid upon irradiation with light emitted from a light emitting diode (LED), wherein the light has a wavelength of from 100 nm to 900 nm.

The wavelength of the light can be in the UV or visible region or higher into the infrared region. In the UV range, UVA, UVB, and UVC are possible, which are characterized by the wavelength of from 320 to 400 nm, from 280 to 320 nm, and from 100 to 280 nm, respectively.

The photocurable resin composition for additive fabrication is highly photosensitive. For example, it has a Critical Exposure (Ec) and a Depth of Penetration (Dp) as measured on a layer of the photocurable resin composition as the composition is curing, wherein Ec is from 0.01 seconds to 6.0 seconds and Dp is from 0.03 mm to 0.2 mm (1 to 8 mils). In an embodiment, the wavelength of the LED light is 365 nm.

In embodiments, Ec is 0.01 seconds to 1, 2, 3, 4, 5, or 6 seconds. In embodiments, Dp is 0.03 to 0.1 mm (1 to 7 mils). In an embodiment, Ec is from 0.01 seconds to 2.0 seconds.

The photosensitivity of the liquid formulations was determined by using a technique similar to the so-called WINDOWPANES™ technique, a technique known to those skilled in the art of stereolithography. In this technique, single-layer test specimens are produced by using different amounts of exposure energies to cure the liquid formulation to solid, and the solid resin layer thicknesses obtained are measured. The resulting layer thickness is plotted on a graph against the natural logarithm of the irradiation energy used to provide a "working curve." The slope of this curve is termed Dp (given in mm or mils). The energy value at which the curve passes through the x-axis is termed Ec (and is the energy at which gelling of the material just takes place; P. Jacobs, Rapid Prototyping and manufacturing, Soc. of Manufacturing Engineers, 1992, p. 270 ff.). Alternatively, the exposure time (in seconds) rather than the exposure energy (in mW/cm²) is used for calculating the Ec values when the intensity of the irradiation light is constant, as in the case of using LED light as the light curing sources.

In a particular embodiment, Dp is from 0.03 mm to 0.2 mm (1 to 8 mils), more particularly from 0.03 mm to 0.1 mm (1 to 7 mils), and in embodiments, from 1 mil to 7 mils or from 2 to 5 mils, even more particularly from 2 mils to 4 mils.

Embodiments of the invention include photocurable resin compositions which display advantageous mechanical properties such as storage modulus as it is curing. For example, the photocurable resin composition, as it is curing has a storage shear modulus (G') value greater than 1.0 × 10⁵ Pa, e.g., from 5.0 × 10⁵ Pa to 1.0 × 10⁶ Pa or to 1.0 × 10⁷ Pa, when measured on a Real Time-Dynamic Mechanical Analyzer (RT-DMA) with an 8 mm plate and a sample gap of 0.10 mm at 3.9 seconds from the beginning of light exposure of 44-50 mW/cm² light intensity for 1.0 second. In some embodiments, the G' value is from 6.0 × 10⁵ Pa to 9.0 × 10⁵ Pa, and in some other embodiments, the G' value is from 7.0 × 10⁵ Pa to 8.0 × 10⁵ Pa.

In accordance with an embodiment, the photocurable resin composition for additive fabrication includes at least one free-radical polymerizable component and at least one cationic polymerizable component.

In accordance with an embodiment of the invention, the photocurable resin composition for additive fabrication of the invention comprises at least one free-radical polymerizable component, that is, a component which undergoes polymerization initiated by free radicals. The free-radical polymerizable components are monomers, oligomers, and/or polymers; they are monofunctional or polyfunctional materials, i.e., have 1, 2, 3, 4, 5, 6, 7, 8, 9, 10, 20, 30, 40, 50, 100, or more functional groups that can polymerize by free radical initiation, may contain aliphatic, aromatic, cycloaliphatic, arylaliphatic, heterocyclic moiety(ies), or any combination thereof. Examples of polyfunctional materials include dendritic polymers such as dendrimers, linear dendritic polymers, dendrigraft polymers, hyperbranched polymers, star branched polymers, and hypergraft polymers; see US 2009/0093564 A1. The dendritic polymers may contain one type of polymerizable functional group or different types of polymerizable functional groups, for example, acrylates and methacrylate functions.

Examples of free-radical polymerizable components include acrylates and methacrylates such as isobornyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, benzyl (meth)acrylate, 4-butylcyclohexyl (meth)acrylate, acryloyl morpholine, (meth)acrylic acid, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, caprolactone acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, tridecyl (meth)acrylate, undecyl (meth)acrylate, lauryl (meth)acrylate, stearyl (meth)acrylate, isostearyl (meth)acrylate, tetrahydrofurfuryl (meth)acrylate, butoxyethyl (meth)acrylate, ethoxydiethylene glycol (meth)acrylate, benzyl (meth)acrylate, phenoxyethyl (meth)acrylate, polyethylene glycol mono(meth)acrylate, polypropylene glycol mono(meth)acrylate, methoxyethylene glycol (meth)acrylate, ethoxyethyl (meth)acrylate, methoxypolyethylene glycol (meth)acrylate, methoxypolypropylene glycol (meth)acrylate, diacetone (meth)acrylamide, beta-carboxyethyl (meth)acrylate, phthalic acid (meth)acrylate, dimethylaminoethyl (meth)acrylate, diethylaminoethyl (meth)acrylate, butylcarbamylethyl (meth)acrylate, n-isopropyl (meth)acrylamide fluorinated (meth)acrylate, 7-amino-3,7-dimethyloctyl (meth)acrylate.

Examples of polyfunctional free-radical polymerizable components include those with (meth)acryloyl groups such as trimethylolpropane tri(meth)acrylate, pentaerythritol (meth)acrylate, ethylene glycol di(meth)acrylate, bisphenol A diglycidyl ether di(meth)acrylate, dicyclopentadiene dimethanol di(meth)acrylate, [2-[1,1-dimethyl-2-[(1-oxoallyl)oxy]ethyl]-5-ethyl-1,3-dioxan-5-yl]methyl acrylate; 3,9-bis(1,1-dimethyl-2-hydroxyethyl)-2,4,8,10-tetraoxaspiro[5.5]undecane di(meth)acrylate; dipentaerythritol monohydroxypenta(meth)acrylate, propoxylated trimethylolpropane tri(meth)acrylate, propoxylated neopentyl glycol di(meth)acrylate, tetraethylene glycol di(meth)acrylate, polyethylene glycol di(meth)acrylate, 1,4-butanediol di(meth)acrylate, 1,6-hexanediol di(meth)acrylate, neopentyl glycol di(meth)acrylate, polybutanediol di(meth)acrylate, tripropyleneglycol di(meth)acrylate, glycerol tri(meth)acrylate, phosphoric acid mono- and di(meth)acrylates, C₇-C₂₀ alkyl di(meth)acrylates, tris(2-hydroxyethyl)isocyanurate tri(meth)acrylate, tris(2-hydroxyethyl)isocyanurate di(meth)acrylate, pentaerythritol tri(meth)acrylate, pentaerythritol tetra(meth)acrylate, dipentaerythritol hexa(meth)crylate, tricyclodecane diyl dimethyl di(meth)acrylate and alkoxylated versions (e.g., ethoxylated and/or propoxylated) of any of the preceding monomers, and also di(meth)acrylate of a diol which is an ethylene oxide or propylene oxide adduct to bisphenol A, di(meth)acrylate of a diol which is an ethylene oxide or propylene oxide adduct to hydrogenated bisphenol A, epoxy (meth)acrylate which is a (meth)acrylate adduct to bisphenol A of diglycidyl ether, diacrylate of polyoxyalkylated bisphenol A, and triethylene glycol divinyl ether, and adducts of hydroxyethyl acrylate.

In accordance with an embodiment, the polyfunctional (meth)acrylates of the polyfunctional component may include all methacryloyl groups, all acryloyl groups, or any combination of methacryloyl and acryloyl groups. In an embodiment, the free-radical polymerizable component is selected from the group consisting of bisphenol A diglycidyl ether di(meth)acrylate, ethoxylated or propoxylated bisphenol A or bisphenol F di(meth)acrylate, dicyclopentadiene dimethanol di(meth)acrylate, [2-[1,1-dimethyl-2-[(1-oxoallyl)oxy]ethyl]-5-ethyl-1,3-dioxan-5-yl]methyl acrylate, dipentaerythritol monohydroxypenta(meth)acrylate, dipentaerythritol hexa(meth)crylate, propoxylated trimethylolpropane tri(meth)acrylate, and propoxylated neopentyl glycol di(meth)acrylate, and any combination thereof.

In another embodiment, the free-radical polymerizable component is selected from the group consisting of bisphenol A diglycidyl ether diacrylate, dicyclopentadiene dimethanol diacrylate, [2-[1,1-dimethyl-2-[(1-oxoallyl)oxy]ethyl]-5-ethyl-1,3-dioxan-5-yl]methyl acrylate, dipentaerythritol monohydroxypentaacrylate, propoxylated trimethylolpropane triacrylate, and propoxylated neopentyl glycol diacrylate, and any combination thereof.

In specific embodiments, the photocurable resin compositions for additive fabrication of the invention include one or more of bisphenol A diglycidyl ether di(meth)acrylate, dicyclopentadiene dimethanol di(meth)acrylate, dipentaerythritol monohydroxypenta(meth)acrylate, propoxylated trimethylolpropane tri(meth)acrylate, and/or propoxylated neopentyl glycol di(meth)acrylate, and more specifically one or more of bisphenol A diglycidyl ether diacrylate, dicyclopentadiene dimethanol diacrylate, dipentaerythritol monohydroxypentaacrylate, propoxylated trimethylolpropane triacrylate, and/or propoxylated neopentyl glycol diacrylate.

The photocurable resin composition for additive fabrication can include any suitable amount of the free-radical polymerizable component, for example, in certain embodiments, in an amount up to 95% by weight of the composition, in certain embodiments, up to 50% by weight of the composition, and in further embodiments from 5% to 25% by weight of the composition.

In accordance with an embodiment, the photocurable resin compositions for additive fabrication of the invention comprise at least one cationically polymerizable component, that is, a component which undergoes polymerization initiated by cations or in the presence of acid generators. The cationically polymerizable components may be monomers, oligomers, and/or polymers, and may contain aliphatic, aromatic, cycloaliphatic, arylaliphatic, heterocyclic moiety(ies), and any combination thereof. Suitable cyclic ether compounds can comprise cyclic ether groups as side groups or groups that form part of an alicyclic or heterocyclic ring system.

The cationic polymerizable component is selected from the group consisting of cyclic ether compounds, cyclic acetal compounds, cyclic thioethers compounds, spiro-orthoester compounds, cyclic lactone compounds, and vinyl ether compounds, and any combination thereof.

Examples of cationically polymerizable components include cyclic ether compounds such as epoxy compounds and oxetanes, cyclic lactone compounds, cyclic acetal compounds, cyclic thioether compounds, spiro orthoester compounds, and vinylether compounds. Specific examples of cationically polymerizable components include bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolac resins, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxycyclohexanecarboxylate, 2-(3,4-epoxycyclohexyl-5,5-spiro-3,4-epoxy)-cyclohexane-1,4-dioxane, bis(3,4-epoxycyclohexylmethyl)adipate, vinylcyclohexene oxide, 4-vinylepoxycyclohexane, vinylcyclohexene dioxide, limonene oxide, limonene dioxide, bis(3,4-epoxy-6-methylcyclohexylmethyl)adipate, 3,4-epoxy-6-methylcyclohexyl-3',4'-epoxy-6'-methylcyclohexanecarboxylate, ε-caprolactone-modified 3,4-epoxycyclohexylmethyl-3',4'-epoxycyclohexane carboxylates, trimethylcaprolactone-modified 3,4-epoxycyclohexylmethyl-3',4'-epoxycyclohexane carboxylates, β-methyl-δ-valerolactone-modified 3,4-epoxycyclohexcylmethyl-3',4'-epoxycyclohexane carboxylates, methylenebis(3,4-epoxycyclohexane), bicyclohexyl-3,3'-epoxide, bis(3,4-epoxycyclohexyl) with a linkage of -O-, -S-, -SO-, -SO₂-, -C(CH₃)₂-, -CBr₂-, -C(CBr₃)₂-, -C(CF₃)2-, -C(CCl₃)₂-, or -CH(C₆H₅)-, dicyclopentadiene diepoxide, di(3,4-epoxycyclohexylmethyl) ether of ethylene glycol, ethylenebis(3,4-epoxycyclohexanecarboxylate), epoxyhexahydrodioctylphthalate, epoxyhexahydro-di-2-ethylhexyl phthalate, 1,4-butanediol diglycidyl ether, 1,6-hexanediol diglycidyl ether, neopentylglycol diglycidyl ether, glycerol triglycidyl ether, trimethylolpropane triglycidyl ether, polyethylene glycol diglycidyl ether, polypropylene glycol diglycidyl ether, polyglycidyl ethers of polyether polyol obtained by the addition of one or more alkylene oxides to aliphatic polyhydric alcohols such as ethylene glycol, propylene glycol, and glycerol, diglycidyl esters of aliphatic long-chain dibasic acids, monoglycidyl ethers of aliphatic higher alcohols, monoglycidyl ethers of phenol, cresol, butyl phenol, or polyether alcohols obtained by the addition of alkylene oxide to these compounds, glycidyl esters of higher fatty acids, epoxidated soybean oil, epoxybutylstearic acid, epoxyoctylstearic acid, epoxidated linseed oil, epoxidated polybutadiene, 1,4-bis[(3-ethyl-3-oxetanylmethoxy)methyl]benzene, 3-ethyl-3-hydroxymethyloxetane, 3-ethyl-3-(3-hydroxypropyl)oxymethyloxetane, 3-ethyl-3-(4-hydroxybutyl)oxymethyloxetane, 3-ethyl-3-(5-hydroxypentyl)oxymethyloxetane, 3-ethyl-3-phenoxymethyloxetane, bis((1-ethyl(3-oxetanyl))methyl)ether, 3-methyl-3-((2-ethylhexyloxy)methyl)oxetane, 3-ethyl-((triethoxysilylpropoxymethyl)oxetane, 3-(meth)-allyloxymethyl-3-ethyloxetane, (3-ethyl-3-oxetanylmethoxy)methylbenzene, 4-fluoro-[1-(3-ethyl-3-oxetanylmethoxy)methyl]benzene, 4-methoxy-[1-(3-ethyl-3-oxetanylmethoxy)methyl]-benzene, [1-(3-ethyl-3-oxetanylmethoxy)ethyl]phenyl ether, isobutoxymethyl(3-ethyl-3-oxetanylmethyl)ether, 2-ethylhexyl(3-ethyl-3-oxetanylmethyl)ether, ethyldiethylene glycol(3-ethyl-3-oxetanylmethyl)ether, dicyclopentadiene (3-ethyl-3-oxetanylmethyl)ether, dicyclopentenyloxyethyl(3-ethyl-3-oxetanylmethyl)ether, dicyclopentenyl(3-ethyl-3-oxetanylmethyl)ether, tetrahydrofurfuyl(3-ethyl-3-oxetanylmethyl)ether, 2-hydroxyethyl(3-ethyl-3-oxetanylmethyl)ether, 2-hydroxypropyl(3-ethyl-3-oxetanylmethyl)ether, and any combination thereof. Examples of polyfunctional materials that are cationically polymerizable include dendritic polymers such as dendrimers, linear dendritic polymers, dendrigraft polymers, hyperbranched polymers, star branched polymers, and hypergraft polymers with epoxy or oxetane functional groups. The dendritic polymers may contain one type of polymerizable functional group or different types of polymerizable functional groups, for example, epoxy and oxetane functions.

In embodiments of the invention, the cationic polymerizable component is at least one selected from the group consisting of a cycloaliphatic epoxy and an oxetane. In a specific embodiment, the cationic polymerizable component is an oxetane, for example, an oxetane containing 2 or more than 2 oxetane groups. In another specific embodiment, the cationic polymerizable component is a cycloaliphatic epoxy, for example, a cycloaliphatic epoxy with 2 or more than 2 epoxy groups.

In an embodiment, the epoxide is 3,4-epoxycyclohexylmethyl-3',4-epoxycyclohexanecarboxylate (available as CELLOXIDE™ 202IP from Daicel Chemical, or as CYRACURE™ UVR-6105 from Dow Chemical), hydrogenated bisphenol A-epichlorohydrin based epoxy resin (available as EPONEX™ 1510 from Hexion), 1,4-cyclohexanedimethanol diglycidyl ether (available as HELOXY™ 107 from Hexion), a mixture of dicyclohexyl diepoxide and nanosilica (available as NANOPOX™), and any combination thereof.

The above-mentioned cationically polymerizable compounds can be used singly or in combination of two or more thereof.

The photocurable resin composition for additive fabrication can include any suitable amount of the cationic polymerizable component, for example, in certain embodiments, in an amount up to 95% by weight of the composition, and in certain embodiments, up to 50% by weight of the composition. In further embodiments the amount of the cationic polymerizable component is from 5% to 70% by weight of the composition. In further embodiments from 5% to 25% by weight of the composition.

In accordance with an embodiment, the polymerizable component of the photocurable resin composition for additive fabrication is polymerizable by both free-radical polymerization and cationic polymerization. An example of such a polymerizable component is a vinyloxy compound, for example, one selected from the group consisting of bis(4-vinyloxybutyl)isophthalate, tris(4-vinyloxybutyl) trimellitate, and combinations thereof. Other examples of such a polymerizable component include those that contain an acrylate and an epoxy group, or an acrylate and an oxetane group, on a same molecule.

In embodiments, the photocurable resin composition for additive fabrication of the present invention includes a photoinitiating system. The photoinitiating system can be a free-radical photoinitiator or a cationic photoinitiator or a photoinitiator that contains both free-radical initiating function and cationic initiating function on the same molecule. The photoinitiator is a compound that chemically changes due to the action of light or the synergy between the action of light and the electronic excitation of a sensitizing dye to produce at least one of a radical, an acid, and a base.

Typically, free radical photoinitiators are divided into those that form radicals by cleavage, known as "Norrish Type I" and those that form radicals by hydrogen abstraction, known as "Norrish type II". The Norrish type II photoinitiators require a hydrogen donor, which serves as the free radical source. As the initiation is based on a bimolecular reaction, the Norrrish type II photoinitiators are generally slower than Norrish type I photoinitiators which are based on the unimolecular formation of radicals. On the other hand, Norrish type II photoinitiators possess better optical absorption properties in the near-UV spectroscopic region. Photolysis of aromatic ketones, such as benzophenone, thioxanthones, benzil, and quinones, in the presence of hydrogen donors, such as alcohols, amines, or thiols leads to the formation of a radical produced from the carbonyl compound (ketyl-type radical) and another radical derived from the hydrogen donor. The photopolymerization of vinyl monomers is usually initiated by the radicals produced from the hydrogen donor. The ketyl radicals are usually not reactive toward vinyl monomers because of the steric hindrance and the delocalization of an unpaired electron.

To successfully formulate a photocurable resin composition for additive fabrication, it is necessary to review the wavelength sensitivity of the photoinitiator(s) present in the composition to determine if they will be activated by the LED light chosen to provide the curing light.

In accordance with an embodiment, the photocurable resin composition for additive fabrication includes at least one free radical photoinitiator, e.g., those selected from the group consisting of benzoylphosphine oxides, aryl ketones, benzophenones, hydroxylated ketones, 1-hydroxyphenyl ketones, ketals, metallocenes, and any combination thereof.

In an embodiment, the photocurable resin composition for additive fabrication includes at least one free-radical photoinitiator selected from the group consisting of 2,4,6-trimethylbenzoyl diphenylphosphine oxide and 2,4,6-trimethylbenzoyl phenyl, ethoxy phosphine oxide, *bis*(2,4,6-trimethylbenzoyl)-phenylphosphineoxide, 2-methyl-1-[4-(methylthio)phenyl]-2-morpholinopropanone-1, 2-benzyl-2-(dimethylamino)-1-[4-(4-morpholinyl) phenyl]-1-butanone, 2-dimethylamino-2-(4-methyl-benzyl)-1-(4-morpholin-4-yl-phenyl)-butan-1-one, 4-benzoyl-4'-methyl diphenyl sulphide, 4,4'- bis(diethylamino) benzophenone, and 4,4'-bis(N,N'-dimethylamino) benzophenone (Michler's ketone), benzophenone, 4-methyl benzophenone, 2,4,6-trimethyl benzophenone, dimethoxybenzophenone, 1-hydroxycyclohexyl phenyl ketone, phenyl (1-hydroxyisopropyl)ketone, 2-hydroxy-1-[4-(2-hydroxyethoxy) phenyl]-2-methyl-1-propanone, 4-isopropylphenyl(1-hydroxyisopropyl)ketone, oligo-[2-hydroxy-2-methyl-1-[4-(1-methylvinyl)phenyl] propanone], camphorquinone, 4,4'-*bis*(diethylamino) benzophenone, benzil dimethyl ketal, *bis*(eta 5-2-4-cyclopentadien-1-yl) *bis*[2,6-difluoro-3-(1*H*-pyrrol-1-yl) phenyl] titanium, and any combination thereof.

For LED light sources emitting in the 300-475 nm wavelength range, especially those emitting at 365 nm, 390 nm, or 395 nm, examples of suitable free-radical photoinitiators absorbing in this area include: benzoylphosphine oxides, such as, for example, 2,4,6-trimethylbenzoyl diphenylphosphine oxide (Lucirin TPO from BASF) and 2,4,6-trimethylbenzoyl phenyl, ethoxy phosphine oxide (Lucirin TPO-L from BASF), *bis*(2,4,6-trimethylbenzoyl)-phenylphosphineoxide (Irgacure 819 or BAPO from Ciba), 2-methyl-1-[4-(methylthio)phenyl]-2-morpholinopropanone-1 (Irgacure 907 from Ciba), 2-benzyl-2-(dimethylamino)-1-[4-(4-morpholinyl) phenyl]-1-butanone (Irgacure 369 from Ciba), 2-dimethylamino-2-(4-methyl-benzyl)-1-(4-morpholin-4-yl-phenyl)-butan-1-one (Irgacure 379 from Ciba), 4-benzoyl-4'-methyl diphenyl sulphide (Chivacure BMS from Chitec), 4,4'-bis(diethylamino) benzophenone (Chivacure EMK from Chitec), and 4,4'-bis(N,N'-dimethylamino) benzophenone (Michler's ketone). Also suitable are mixtures thereof.

Additionally, photosensitizers are useful in conjunction with photoinitiators in effecting cure with LED light sources emitting in this wavelength range. Examples of suitable photosensitizers include: anthraquinones, such as 2-methylanthraquinone, 2-ethylanthraquinone, 2-tertbutylanthraquinone, 1-chloroanthraquinone, and 2-amylanthraquinone, thioxanthones and xanthones, such as isopropyl thioxanthone, 2-chlorothioxanthone, 2,4-diethylthioxanthone, and 1-chloro-4-propoxythioxanthone, methyl benzoyl formate (Darocur MBF from Ciba), methyl-2-benzoyl benzoate (Chivacure OMB from Chitec), 4-benzoyl-4'-methyl diphenyl sulphide (Chivacure BMS from Chitec), 4,4'-bis(diethylamino) benzophenone (Chivacure EMK from Chitec).

It is possible for LED UV light sources to be designed to emit light at shorter wavelengths. In embodiments, a photosensitizer is used when curing with LED light sources emitting at wavelengths from between 100 and 300 nm. When photosensitizers, such as those previously listed are present in the formulation, other photoinitiators absorbing at shorter wavelengths can be used. Examples of such photoinitiators include: benzophenones, such as benzophenone, 4-methyl benzophenone, 2,4,6-trimethyl benzophenone, and dimethoxybenzophenone, and , 1-hydroxyphenyl ketones, such as 1-hydroxycyclohexyl phenyl ketone, phenyl (1-hydroxyisopropyl)ketone, 2-hydroxy-1-[4-(2-hroxyethoxy) phenyl]-2-methyl-1-propanone, and 4-isopropylphenyl(1-hydroxyisopropyl)ketone, benzil dimethyl ketal, and oligo-[2-hydroxy-2-methyl-1-[4-(1-methylvinyl)phenyl] propanone] (Esacure KIP 150 from Lamberti).

LED light sources can also be designed to emit visible light. For LED light sources emitting light at wavelengths from 475 nm to 900 nm, examples of suitable free radical photoinitiators include: camphorquinone, 4,4'-bis(diethylamino) benzophenone (Chivacure EMK from Chitec), 4,4'-bis(N,N'-dimethylamino) benzophenone (Michler's ketone), bis(2,4,6-trimethylbenzoyl)-phenylphosphineoxide (Irgacure 819 or BAPO from Ciba), metallocenes such as bis (eta 5-2-4-cyclopentadien-1-yl) bis [2,6-difluoro-3-(1H-pyrrol-1-yl) phenyl] titanium (Irgacure 784 from Ciba), and the visible light photoinitiators from Spectra Group Limited, Inc. such as H-Nu 470, H-Nu-535, H-Nu-635, H-Nu-Blue-640, and H-Nu-Blue-660. It is often desirable to employ a photosensitizer with a photoinitiator for LED light sources emitting between 475 nm and 900 nm. In one embodiment of the instant claimed invention, the light emitted by the LED is UVA radiation, which is radiation with a wavelength between 320 and 400nm. In one embodiment of the instant claimed invention, the light emitted by the LED is UVB radiation, which is radiation with a wavelength between 280 and 320nm. In one embodiment of the instant claimed invention, the light emitted by the LED is UVC radiation, which is radiation with a wavelength between 100 and 280nm.

The photocurable resin composition for additive fabrication can include any suitable amount of the free-radical photoinitiator, for example, in certain embodiments, in an amount up to 15% by weight of the composition, in certain embodiments, up to about 10% by weight of the composition, and in further embodiments from 1% to 5% by weight of the composition.

In accordance with an embodiment, the photocurable resin composition for additive fabrication includes a photoinitiating system that is a photoinitiator having both cationic initiating function and free radical initiating function.

In accordance with an embodiment, the photocurable resin composition for additive fabrication includes a cationic photoinitiator. The cationic photoinitiator generates photoacids upon irradiation of light. They generate Brönsted or Lewis acids upon irradiation. Any suitable cationic photoinitiator can be used, for example, those selected from the group consisting of onium salts, halonium salts, iodosyl salts, selenium salts, sulfonium salts, sulfoxonium salts, diazonium salts, metallocene salts, isoquinolinium salts, phosphonium salts, arsonium salts, tropylium salts, dialkylphenacylsulfonium salts, thiopyrilium salts, diaryl iodonium salts, triaryl
sulfonium salts, sulfonium antimonate salts, ferrocenes, di(cyclopentadienyliron)arene salt compounds, and pyridinium salts, and any combination thereof. Onium salts, e.g., iodonium salts, sulfonium salts and ferrocenes, have the advantage that they are thermally stable. Thus, any residual photoinitiator does not continue to cure after the removal of the irradiating light. Cationic photoinitiators offer the advantage that they are not sensitive to oxygen present in the atmosphere.

The photocurable resin composition for additive fabrication of the invention includes at least one cationic photoinitiator, wherein the cationic photoinitiator is selected from the group consisting of aromatic diazonium salts, aromatic sulfonium salts, aromatic iodonium salts, metallocene based compounds, aromatic phosphonium salts and silanol aluminium complexes, and any combination thereof. In an embodiment, the cationic photoinitiator is selected from the group consisting of aromatic sulfonium salts, aromatic iodonium salts, and metallocene based compounds, and any combination thereof. In another embodiment, the cationic photoinitiator is selected from the group consisting of triarylsulfonium salts, diaryliodonium salts, and metallocene based compounds, and any combination thereof.

In a particular embodiment, the cationic photoinitiator has an anion selected from the group consisting of BF₄⁻, AsF₆⁻, SbF₆⁻, PF₆⁻, B(C₆F₅)₄⁻, perfluoroalkylsulfonates, perfluoroalkylphosphates, and carborane anions.

In an embodiment, the cationic photoinitiator has a cation selected from the group consisting of aromatic sulfonium salts, aromatic iodonium salts, and metallocene based compounds with at least an anion selected from the group consisting of SbF₆ , PF₆⁻, B(C₆F₅₎₄⁻, perfluoroalkylsulfonates, perfluoroalkylphosphates, and (CH₆B₁₁Cl₆)⁻.

In a particular embodiment, the cationic photoinitiator is an aromatic sulfonium salt based cationic photoinitiator selected from the group consisting of 4-(4-benzoylphenylthio)phenyldiphenylsulfonium hexafluoroantimonate, 4-(4-benzoylphenylthio)phenylbis(4-hydroxyethyloxyphenyl)sulfonium hexafluoroantimonate, 4-(4-benzoylphenylthio)phenylbis(4-fluorophenyl)sulfonium hexafluoroantimonate, 4-(4-benzoylphenylthio)phenylbis(4-chlorophenyl)sulfonium hexafluoroantimonate, 4-[4-(3-chlorobenzoyl)phenylthio]phenylbis(4-fluorophenyl)sulfonium hexafluoroantimonate, 4-(4-benzoylphenylthio)phenylbis(4-methylphenyl)sulfonium hexafluoroantimonate, 4-(4-benzoylphenylthio)phenylbis(4-hydroxyethylphenyl)sulfonium hexafluoroantimonate, 4-[4-(4-hydroxyethyloxybenzoyl)phenylthio]phenylbis(4-fluoro phenyl)sulfonium hexafluoroantimonate, 4-[4-(4-hydroxyethyloxybenzoyl)phenylthio]phenyldiphenylsulfonium hexafluoroantimonate, 4-[4-(4-hydroxyethyloxybenzoyl)phenylthio]phenylbis(4-hydroxyethyloxyphenyl)sulfonium hexafluoroantimonate, 4-(4-benzoylphenylthio)phenylbis(4-methoxyethoxyphenyl)sulfonium hexafluoroantimonate, 4-[4-(3-methoxybenzoyl)phenylthio]phenyldiphenylsulfonium hexafluoroantimonate, 4-[4-(3-methoxycarbonylbenzoyl)phenylthio]phenyldiphenylsulfonium hexafluoroantimonate, 4-[4-(2-hydroxymethylbenzoyl)phenylthio]phenyldiphenylsulfonium hexafluoroantimonate, 4-[4-(4-methylbenzoyl)phenylthio]phenylbis(4-fluorophenyl)sulfonium hexafluoroantimonate, 4-[4-(4-)phenylthio]phenylbis(4-fluorophenyl)sulfonium hexafluoroantimonate, 4-[4-(4-fluorobenzoyl)phenylthio]phenylbis(4-fluorophenyl)sulfonium hexafluoroantimonate, 4-[4-(2-methoxycarbonylbenzoyl)phenylthio]phenylbis(4-fluoro phenyl)sulfonium hexafluoroantimonate, bis[4-(diphenylsulfonio)phenyl]sulfide bishexafluorophosphate, bis[4-(diphenylsulfonio)phenyl]sulfide bistetrafluoroborate, bis[4-(diphenylsulfonio)phenyl]sulfide tetrakis(pentafluorophenyl)borate, diphenyl-4-(phenylthio)phenylsulfonium hexafluorophosphate, diphenyl-4-(phenylthio)phenylsulfonium tetrafluoroborate, diphenyl-4-(phenylthio)phenylsulfonium tetrakis(pentafluorophenyl)borate, triphenylsulfonium hexafluorophosphate, triphenylsulfonium hexafluoroantimonate, triphenylsulfonium tetrafluoroborate, triphenylsulfonium tetrakis(pentafluorophenyl)borate, bis[4-(di(4-(2-hydroxyethoxy))phenylsulfonio)phenyl]sulfide bishexafluorophosphate, bis[4-(di(4-(2-hydroxyethoxy))phenylsulfonio)phenyl]sulfide bistetrafluoroborate, and bis[4-(di(4-(2-hydroxyethoxy))phenylsulfonio)phenyl]sulfide tetrakis(pentafluorophenyl)borate, and any combination thereof.

In another embodiment, the cationic photoinitiator is an aromatic iodonium salt based cationic photoinitiator selected from the group consisting of diphenyliodonium hexafluorophosphate, diphenyliodonium hexafluoroantimonate, diphenyliodonium tetrafluoroborate, diphenyliodonium tetrakis(pentafluorophenyl)borate, bis(dodecylphenyl)iodonium hexafluorophosphate, bis(dodecylphenyl)iodonium hexafluoroantimonate, bis(dodecylphenyl)iodonium tetrafluoroborate, bis(dodecylphenyl)iodonium tetrakis(pentafluorophenyl)borate, 4-methylphenyl-4-(1-methylethyl)phenyliodonium hexafluorophosphate, 4-methylphenyl-4-(1-methylethyl)phenyliodonium hexafluoroantimonate, 4-methylphenyl-4-(1-methylethyl)phenyliodonium tetrafluoroborate, and 4-methylphenyl-4-(1-methylethyl)phenyliodonium tetrakis(pentafluorophenyl)borate, and any combination thereof.

In certain embodiments, the cationic photoinitiator is selected from the group consisting of tetrakis(pentafluorophenyl)borate or hexafluoroantimonate salt of 4-(4-benzoylphenylthio)phenyldiphenylsulfonium, 4-(4-benzoylphenylthio)phenylbis(4-hydroxyethyloxyphenyl)sulfonium, 4-(4-benzoylphenylthio)phenylbis(4-fluorophenyl)sulfonium, 4-(4-benzoylphenylthio)phenylbis(4-chlorophenyl)sulfonium, 4-[4-(3-chlorobenzoyl)phenylthio]phenylbis(4-fluorophenyl)sulfonium, 4-[4-(2-chlorobenzoyl)phenylthio]phenylbis(4-fluorophenyl)sulfonium, (4-thiophenoxyphenyl)diphenylsulfonium, S,S,S',S'-tetraphenylthiobis(4,1-phenylene)disulfonium, triphenylsulfonium, (chlorophenyl)diphenylsulfonium, chloro[S-(phenyl)thianthrenium], S-(phenyl)thianthrenium, diphenyl-4-(4'-thiophenoxy)thiophenoxyphenylsulfonium, phenyldi(4-thiophenoxyphenyl)sulfonium, S-(4-thiophenoxyphenyl)thianthrenium, and (thiodi-4,1-phenylene)bis[bis[4-(2-hydroxyethoxy)phenyl]sulfonium, tris(4-(4-acetylphenyl)thiophenyl)sulfonium, bis(4-dodecylphenyl)iodonium, [4-[(2-hydroxytetradecyl)oxy]phenyl]phenyliodonium, (4-methylphenyl)[4-[[2-[[[[3-(trifluoromethyl)phenyl]amino]carbonyl]oxy]tetradecyl]oxy]phenyl]iodonium, bis(4-dodecylphenyl)iodonium, [4-(1-methylethyl)phenyl](4-methylphenyl)iodonium, and any combination thereof.

In an illustrative embodiment, the photocurable resin composition for additive fabrication includes a cationic photoinitiator selected from the group consisting of triarylsulfonium SbF₆⁻, triarylsulfonium borate, tris(4-(4-acetylphenyl)thiophenyl)sulfonium tetrakis(pentafluorophenyl)borate, diaryliodonium borate, iodonium [4-(1-methylethyl)phenyl](4-methylphenyl)-tetrakis(pentafluorophenyl)borate, and any combination thereof. A nonnucleophilic anion serves as the counterion. Examples of such anions include BF₄⁻, AsF₆⁻, SbF₆⁻, PF₆⁻, B(C₆F₅)₄⁻, perfluoroalkylsulfonates, perfluoroalkylphosphates, and carborane anions such as (CH₆B₁₁Cl₆)⁻.

Examples of cationic photoinitiators useful for curing at 300-475 nm, particularly at 365 nm UV light, without a sensitizer include 4-[4-(3-chlorobenzoyl)phenylthio]phenylbis(4-fluorophenyl)sulfonium hexafluoroantimonate, 4-[4-(3-chlorobenzoyl)phenylthio]phenylbis(4-fluorophenyl)sulfonium tetrakis(pentafluorophenyl)borate, and tris(4-(4-acetylphenyl)thiophenyl)sulfonium tetrakis(pentafluorophenyl)borate (GSID4480-1 also known as IRGACURE® PAG 290) from Ciba used in some of the example compositions.

In some embodiments it is desirable for the photocurable resin composition for additive fabrication to include a photosensitizer. The term "photosensitizer" is used to refer to any substance that either increases the rate of photoinitiated polymerization or shifts the wavelength at which polymerization occurs; see textbook by G. Odian, Principles of Polymerization, 3^{rd} Ed., 1991, page 222.Examples of photosensitizers include those selected from the group consisting of methanones, xanthenones, pyrenemethanols, anthracenes, pyrene, perylene, quinones, xanthones, thioxanthones, benzoyl esters, benzophenones, and any combination thereof. Particular examples of photosensitizers include those selected from the group consisting of [4-[(4-methylphenyl)thio]phenyl]phenyl methanone, isopropyl-9H-thioxanthen-9-one, 1-pyrenemethanol, 9-(hydroxymethyl)anthracene, 9,10-diethoxyanthracene, 9,10-dimethoxyanthracene, 9,10-dipropoxyanthracene, 9,10-dibutyloxyanthracene, 9-anthracenemethanol acetate, 2-ethyl-9,10-dimethoxyanthracene, 2-methyl-9,10-dimethoxyanthracene, 2-t-butyl-9,10-dimethoxyanthracene, 2-ethyl-9,10-diethoxyanthracene and 2-methyl-9,10-diethoxyanthracene, anthracene, anthraquinones, 2-methylanthraquinone, 2-ethylanthraquinone, 2-tertbutylanthraquinone, 1-chloroanthraquinone, 2-amylanthraquinone, thioxanthones and xanthones, isopropyl thioxanthone, 2-chlorothioxanthone, 2,4-diethylthioxanthone, 1-chloro-4-propoxythioxanthone, methyl benzoyl formate, methyl-2-benzoyl benzoate, 4-benzoyl-4'-methyl diphenyl sulphide, 4,4'- bis(diethylamino) benzophenone, and any combination thereof.

Additionally, photosensitizers are useful in combination with photoinitiators in effecting cure with LED light sources emitting in the wavelength range of 300-475 nm. Examples of suitable photosensitizers include: anthraquinones, such as 2-methylanthraquinone, 2-ethylanthraquinone, 2-tertbutylanthraquinone, 1-chloroanthraquinone, and 2-amylanthraquinone, thioxanthones and xanthones, such as isopropyl thioxanthone, 2-chlorothioxanthone, 2,4-diethylthioxanthone, and 1-chloro-4-propoxythioxanthone, methyl benzoyl formate (Darocur MBF from Ciba), methyl-2-benzoyl benzoate (Chivacure OMB from Chitec), 4-benzoyl-4'-methyl diphenyl sulphide (Chivacure BMS from Chitec), 4,4'-bis(diethylamino) benzophenone (Chivacure EMK from Chitec).

In an embodiment, the photosensitizer is a fluorone, e.g., 5,7-diiodo-3-butoxy-6-fluorone, 5,7-diiodo-3-hydroxy-6-fluorone, 9-cyano-5,7-diiodo-3-hydroxy-6-fluorone, or a photosensitizer is 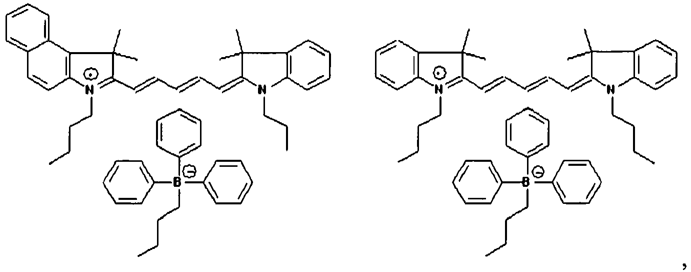 and any combination thereof.

The photocurable resin composition for additive fabrication can include any suitable amount of the photosensitizer, for example, in certain embodiments, in an amount up to 10% by weight of the composition, in certain embodiments, up to 5% by weight of the composition, and in further embodiments from 0.05% to 2% by weight of the composition.

When photosensitizers are employed, other photoinitiators absorbing at shorter wavelengths can be used. Examples of such photoinitiators include: benzophenones, such as benzophenone, 4-methyl benzophenone, 2,4,6-trimethyl benzophenone, and dimethoxybenzophenone, and 1-hydroxyphenyl ketones, such as 1-hydroxycyclohexyl phenyl ketone, phenyl (1-hydroxyisopropyl)ketone, 2-hydroxy-1-[4-(2-hydroxyethoxy) phenyl]-2-methyl-1-propanone, and 4-isopropylphenyl(1-hydroxyisopropyl)ketone, benzil dimethyl ketal, andoligo-[2-hydroxy-2-methyl-1-[4-(1-methylvinyl)phenyl] propanone] (Esacure KIP 150 from Lamberti). These photoinitiators when used in combination with a photosensitizer are suitable for use with LED light sources emitting at wavelengths from 100 nm to 300 nm.

LED light sources that emit visible light are also known. For LED light sources emitting light at wavelengths greater than 400 nm, e.g., from 475 nm to 900 nm, examples of suitable photoinitiators include: camphorquinone, 4,4'-*bis*(diethylamino) benzophenone (Chivacure EMK from Chitec), 4,4'-*bis*(N,N'-dimethylarnino) benzophenone (Michler's ketone), *bis*(2,4,6-trimethylbenzoyl)-phenylphosphineoxide (Irgacure 819 or BAPO from Ciba), metallocenes such as *bis*(eta 5-2-4-cyclopentadien-1-yl) *bis*[2,6-difluoro-3-(1*H*-pyrrol-1-yl) phenyl] titanium (Irgacure 784 from Ciba), and the visible light photoinitiators from Spectra Group Limited, Inc. such as H-Nu 470, H-Nu-535, H-Nu-635, H-Nu-Blue-640, and H-Nu-Blue-660.

A photosensitizer or co-initiator may be used to improve the activity of the cationic photoinitiator. It is for either increasing the rate of photoinitiated polymerization or shifting the wavelength at which polymerization occurs. The sensitizer used in combination with the above-mentioned cationic photoinitiator is not particularly limited. A variety of compounds can be used as photosensitizers, including heterocyclic and fused-ring aromatic hydrocarbons, organic dyes, and aromatic ketones. Examples of sensitizers include compounds disclosed by J. V. Crivello in *Advances in Polymer Science*, 62, 1 (1984), and by J. V. Crivello & K. Dietliker, "Photoinitiators for Cationic Polymerization" in Chemistry & technology of UV & EB formulation for coatings, inks & paints. Volume III, Photoinitiators for free radical and cationic polymerization, by K. Dietliker; [Ed. by P.K.T. Oldring], SITA Technology Ltd, London, 1991. Specific examples include polyaromatic hydrocarbons and their derivatives such as anthracene,
pyrene, perylene and their derivatives, thioxanthones, a-hydroxyalkylphenones, 4-benzoyl-4'-methyldiphenyl sulfide, acridine orange, and benzoflavin.

There are a large number of known and technically proven cationic photoinitiators that are suitable. They include, for example, onium salts with anions of weak nucleophilicity. Examples are halonium salts, iodosyl salts or sulfonium salts, such as are described in published European patent application EP 153904 and WO 98/28663, sulfoxonium salts, such as described, for example, in published European patent applications EP 35969, 44274, 54509, and 164314, or diazonium salts, such as described, for example, in U.S. Pat. Nos. 3,708,296 and 5,002,856. Other cationic photoinitiators are metallocene salts, such as described, for example, in published European applications EP 94914 and 94915.

A survey of other current onium salt initiators and/or metallocene salts can be found in "UV Curing, Science and Technology", (Editor S. P. Pappas, Technology Marketing Corp., 642 Westover Road, Stamford, Conn., U.S.A.) or "Chemistry & Technology of UV & EB Formulation for Coatings, Inks & Paints", Vol. 3 (edited by P. K. T. Oldring).

Suitable ferrocene type cationic photoinitiators include, for example, di(cyclopentadienyliron)arene salt compounds of formula (I) as disclosed in Chinese Patent No. CN 101190931: 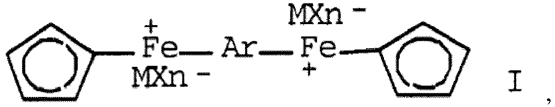 wherein anion MXn is selected from BF4, PF6, SbF6, AsF6, (C6F5)4B, ClO4, CF3SO3, FSO3, CH3SO3, C4F9SO3, and Ar is a fused ring or polycyclic arene.

Other illustrative ferrocene type cationic photoinitiators include, for example, (η6-Carbazole)(η5-cyclopenta-dienyl) iron hexafluorophosphate salts, specifically [cyclopentadiene-Fe-N-butylcarbazole] hexafluoro-phosphate (C4-CFS PF6) and [cyclopentadiene-Fe-N-octyl-carbazole] hexafluorophosphate (C8-CFS PF6), bearing C4 and C8 alkyl chains, respectively, on the nitrogen atom (see Polymer Eng. & Science (2009), 49(3), 613-618); ferrocenium dication salts, e.g., biphenyl bis[(π-cyclopentadienyl) iron] hexafluorophosphate ([bis(Cp-Fe)-biphenyl] (PF6)2) and straight cyclopentadien-iron-biphenyl hexafluorophosphate ([Cp-Fe-biphenyl]+PF6-) as disclosed in Chinese J. Chem. Engnrng (2008), 16(5), 819-822 and Polymer Bulltn (2005), 53(5-6), 323-331; cyclopentadienyl-Fe-carbazole hexafluorophosphate ([Cp-Fe-carbazole]+PF6-), cyclopentadienyl-Fe-N-ethylcarbazole hexafluorophosphate ([Cp-Fe-n-ethylcarbazole]+PF6-) and cyclopentadienyl -Fe-aminonaphthalene hexafluorophosphate ([Cp-Fe-aminonaphthalene]+PF6-) as disclosed in J Photochem. & Photobiology, A: Chemistry (2007), 187(2-3), 389-394 and Polymer Intnl (2005), 54(9), 1251-1255; alkoxy-substituted ferrocenium salts, for example, [cyclopendadien-Fe-anisole]PF6, [cyclopendadien-Fe-anisole]BF4, [cyclopendadien-Fe-diphenylether]PF6, [cyclo-pendadien-Fe-diphenylether]BF4, and [cyclopendadien-Fe-diethoxy-benzene]PF6, as disclosed in Chinese J. of Chem Engnrng (2006), 14(6), 806-809; cyclopentadiene-iron-arene tetrafluoroborates, for example, cyclopentadiene-iron-naphthalene tetrafluoroborate ([Cp-Fe-Naph] BF4) salt, as disclosed in Imaging Science J (2003), 51(4), 247-253; ferrocenyl tetrafluoroborate ([Cp-Fe-CP]BF4), as disclosed in Ganguang Kexue Yu Guang Huaxue (2003), 21(1), 46-52; [CpFe(η6-tol)]BF4, as disclosed in Ganguang Kexue Yu Guang Huaxue (2002), 20(3), 177-184, Ferrocenium salts (η6-α-naphthoxybenzene) (η5-cyclopentadienyl) iron hexafluorophosphate (NOFC-1) and (η6-β-naphthoxybenzene) (η5-cyclopentadienyl) iron hexafluorophosphate (NOFC-2), as disclosed in Int. J of Photoenergy (2009), Article ID 981065; (η6-Diphenyl-methane) (η5-cyclopentadienyl) iron hexafluorophosphate and (η6-benzophenone) (η5-cyclopenta-dienyl) iron hexafluorophosphate, as disclosed in Progress in Organic Coatings (2009), 65(2), 251-256; [CpFe(η6-isopropyl-benzene)]PF6, as disclosed in Chem Comm (1999), (17), 1631-1632; and any combination thereof.

Suitable onium type cationic photoinitiators include, for example, iodonium and sulfonium salts, as disclosed in Japanese Patent JP 2006151852. Other illustrative onium type photoinitiators include, for example, onium salts such as, diaryliodonium salts, triarylsulfonium salts, aryl-diazonium salts, ferrocenium salts, diarylsulfoxonium salts, diaryl-iodoxonium salts, triaryl-sulfoxonium salts, dialkylphenacyl-sulfonium salts, dialkylhydroxy-phenylsulfonium salts, phenacyl-triarylphosphonium salts, and phenacyl salts of heterocyclic nitrogen-containing compounds, as disclosed in U.S. Patent Nos. 5,639,413; 5,705,116; 5,494618; 6,593,388; and Chemistry of Materials (2002), 14(11), 4858-4866; aromatic sulfonium or iodonium salts as disclosed in U.S. Patent Application No. 2008/0292993; diaryl-, triaryl-, or dialkylphenacylsulfonium salts, as disclosed in US2008260960 and J. Poly Sci, Part A (2005), 43(21), 5217; diphenyl-iodonium hexafluorophosphate (Ph2I+PF6-), as disclosed in Macromolecules (2008), 41(10), 3468-3471; onium salts using onium salts using less toxic anions to replace, e.g., SbF6-. Mentioned are anions: B(C6F5)4-, Ga(C6F5)4- and perfluoroalkyl fluorophosphate, PFnRf(6-n)-, as disclosed in Nettowaku Porima (2007), 28(3), 101-108; Photoactive allyl ammonium salt (BPEA) containing benzophenone moiety in the structure, as disclosed in Eur Polymer J (2002), 38(9), 1845-1850; 1-(4-Hydroxy-3-methylphenyl) tetrahydrothiophenium hexafluoroantimonate, as disclosed in Polymer (1997), 38(7), 1719-1723; and any combination thereof.

Illustrative iodonium type cationic photoinitiators include, for example, diaryliodonium salts having counterions like hexafluorophosphate and the like, such as, for example, (4-n-pentadecyloxy-phenyl)phenyliodonium hexafluoroantimonate, as disclosed in US2006041032; diphenyliodonium hexafluorophosphate, as disclosed in US4394403 and Macromolecules (2008), 41(2), 295-297; diphenyliodonium ions as disclosed in Polymer (1993), 34(2), 426-8; Diphenyliodonium salt with boron tetrafluoride (Ph2I+ BF4-), as disclosed in Yingyong Huaxue (1990), 7(3), 54-56; SR-1012, a diaryldiodonium salt, as disclosed in Nuclear Inst. & Methods in Physics Res, B (2007), 264(2), 318-322; diaryliodonium salts, e.g., 4,4'-di-tert-butyldiphenyl-iodonium hexafluoroarsenate, as disclosed in J Polymr Sci, Polymr Chem Edition (1978), 16(10), 2441-2451; Diaryliodonium salts containing complex metal halide anions such as diphenyliodonium fluoroborate, as disclosed in J Polymr Sci, Poly Sympos (1976), 56, 383-95; and any combination thereof.

Illustrative sulfonium type cationic photoinitiators include, for example, UVI 6992 (sulfonium salt) as disclosed in Japanese patent JP2007126612; compounds of the formula: 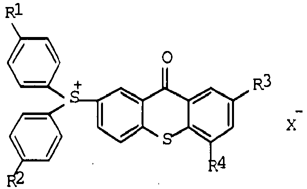 where R1-2 = F; R3 = isopropyl; R4 = H; X = PF6, as disclosed in Japanese patent JP10101718; thioxanthone-based sulfonium salts, e.g., of the formula: 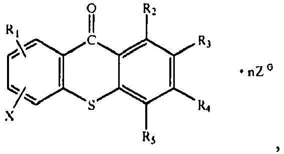 as disclosed in U.S. Patent No. 6,054,501; (Acyloxyphenyl)sulfonium salts of the type R₃-xS+R3x A-, where A- is a non-nucleophilic anion such as AsF₆-, and R3 may be the phenyl group shown below: 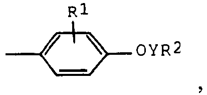 as disclosed in U.S. Patent No. 5,159,088; 9,10-dithiophenoxyanthracene alkyldiarylsulfonium salts, e.g., ethylphenyl(9-thiophenoxy-anthracenyl-10) sulfonium hexafluoroantimonate, and the like, as disclosed in U.S. Patent No. 4,760,013; etc.; triphenylsulfonium hexafluorophosphate salt, as disclosed in U.S. Patent No. 4,245,029; S,S-dimethyl-S-(3,5-dimethyl-2-hydroxyphenyl)sulfonium salts, as disclosed in J Poly Sci, Part A (2003), 41(16), 2570-2587; Anthracene-bound sulfonium salts, as disclosed in J Photochem & Photobiology, A: Chemistry (2003), 159(2), 161-171; triarylsulfonium salts, as disclosed in J Photopolymer Science & Tech (2000), 13(1), 117-118 and J Poly Science, Part A (2008), 46(11), 3820-29; S-aryl-S,S-cycloalkylsulfonium salts, as disclosed in J Macromol Sci, Part A (2006), 43(9), 1339-1353; dialkylphenacylsulfonium salts, as disclosed in UV & EB Tech Expo & Conf, May 2-5, 2004, 55-69 and ACS Symp Ser (2003), 847, 219-230; Dialkyl(4-hydroxyphenyl)sulfonium salts, and their isomeric dialkyl(2-hydroxyphenyl)sulfonium salts, as disclosed in ACS 224th Natnl Meeting, August 18-22, 2002, POLY-726; Dodecyl(4-hydroxy-3,5-dimethylphenyl)methylsulfonium hexafluorophosphate and similar alkyl analogs other than dodecyl. Tetrahydro-1-(4-hydroxy-3,5-dimethylphenyl)thiophenium hexafluorophosphate and tetrahydro-1-(2-hydroxy-3,5-dimethylphenyl)thiophenium hexafluorophosphate, as disclosed in ACS Polymer Preprints (2002), 43(2), 918-919; photoinitiators with the general structure Ar'S+CH3(C12H25)SbF6-, where Ar' is phenacyl (I), 2-indanonyl (II), 4-methoxyphenacyl (III), 2-naphthoylmethyl (IV), 1-anthroylmethyl (V), or 1-pyrenoylmethyl (VI), as disclosed in J Polymr Sci, Part A (2000), 38(9), 1433-1442; Triarylsulfonium salts Ar3S+MXn- with complex metal halide anions such as BF4-, AsF6-, PF6-, and SbF6-, as disclosed in J Polymr Sci, Part A (1996), 34(16), 3231-3253; Dialkylphenacylsulfonium and dialkyl(4-hydroxyphenyl) sulfonium salts, as disclosed in Macromolecules (1981), 14(5), 1141-1147; Triarylsulfonium salts R2R1S+MFn- (R, R1 = Ph or substituted phenyl; M = B, As, P; n = 4 or 6) and the sulfonium salt of formula (I): 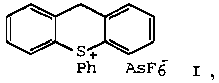 as disclosed in J. Polymr. Sci, Polymr Chem Edition (1979), 17(4), 977-99; aromatic sulfonium salts with, e.g., PF6- anion, e.g., UVI 6970, as disclosed in JP 2000239648; and any combination thereof.

Suitable pyridinium type cationic photoinitiators include, for example, N-ethoxy 2-methylpyridinium hexafluorophosphate (EMP+ PF6-), as disclosed in Turkish J of Chemistry (1993), 17(1), 44-49; Charge-transfer complexes of pyridinium salts and aromatic electron donors (hexamethyl-benzene and 1,2,4-trimethyoxy-benzene), as disclosed in Polymer (1994), 35(11), 2428-31; N,N'-diethoxy-4,4'-azobis(pyridinium) hexafluorophosphate (DEAP), as disclosed in Macromolecular Rapid Comm (2008), 29(11), 892-896; and any combination thereof.

Other suitable cationic photoinitiators include, for example, Acylgermane based photoinitiator in the presence of onium salts, e.g., benzoyltrimethylgermane (BTG) and onium salts, such as diphenyl-iodonium hexafluorophosphate (Ph2I+PF6-) or N-ethoxy-2-methyl-pyridinium hexafluorophosphate (EMP+PF6-), as disclosed in Macromolecules (2008), 41(18), 6714-6718; Di-Ph diselenide (DPDS), as disclosed in Macromolecular Symposia (2006), 240, 186-193; N-phenacyl-N,N-dimethyl-anilinium hexafluoroantimonate (PDA+SbF6-), as disclosed in Macromol Rapid Comm (2002), 23(9), 567-570; Synergistic blends of: diaryliodonium hexafluoro-antimonate (IA) with tolylcumyl-iodonium tetrakis(pentafluorophenyl)borate (IB), and cumenecyclopentadienyliron(II) hexafluorophosphate with IA and IB, as disclosed in Designed Monomers and Polymers (2007), 10(4), 327-345; Diazonium salts, e.g., 4-(hexyloxy)-substituted diazonium salts with complex anions, as disclosed in ACS Symp Series (2003), 847, 202-212; 5-Arylthianthrenium salts, as disclosed in J Poly Sci, Part A (2002), 40(20), 3465-3480; and any combination thereof.

Other suitable cationic photoinitiators include, for example, triarylsulfonium salts such as triarylsulfonium borates modified for absorbing long wavelength UV. Illustrative examples of such modified borates include, for example, SP-300 available from Denka, tris(4-(4-acetylphenyl)thiophenyl)sulfonium tetrakis(pentafluorophenyl)borate (GSID4480-1 or Irgacure PAG-290) available from Ciba/BASF, and those photoinitiators disclosed in WO1999028295 WO2004029037; WO2009057600; US6368769 WO2009047105; WO2009047151; WO2009047152; US 20090208872; and US 7611817.

Preferred cationic photoinitiators include a mixture of: bis[4-diphenylsulfoniumphenyl]sulfide bishexafluoroantimonate; thiophenoxyphenylsulfonium hexafluoroantimonate (available as Chivacure 1176 from Chitec); tris(4-(4-acetylphenyl)thiophenyl)sulfonium tetrakis(pentafluorophenyl)borate (GSID4480-1 from Ciba/BASF), iodonium, [4-(1-methylethyl)phenyl](4-methylphenyl)-, tetrakis(pentafluorophenyl)borate (available as Rhodorsil 2074 from Rhodia), 4-[4-(2-chlorobenzoyl)phenylthio]phenylbis(4-fluorophenyl)sulfonium hexafluoroantimonate (as SP-172) and SP-300 (both available from Adeka).

The photocurable resin composition for additive fabrication can include any suitable amount of the cationic photoinitiator, for example, in certain embodiments, in an amount up to 50% by weight of the composition, in certain embodiments, up to 20% by weight of the composition, and in further embodiments from 1% to 10% by weight of the composition. In a further embodiment from 0.4 wt% to 6.5 wt% of the composition. In an embodiment, the above ranges are particularly suitable for use with epoxy monomers.

In accordance with an embodiment, the photocurable resin composition for additive fabrication can further include a chain transfer agent, particularly a chain transfer agent for a cationic monomer. The chain transfer agent has a functional group containing active hydrogen. Examples of the active hydrogen-containing functional group include an amino group, an amide group, a hydroxyl group, a sulfo group, and a thiol group. In an embodiment, the chain transfer agent terminates the propagation of one type of polymerization, i.e., either cationic polymerization or free-radical polymerization and initiates a different type of polymerization, i.e., either free-radical polymerization or cationic polymerization. In accordance with an embodiment, chain transfer to a different monomer is a preferred mechanism. In embodiments, chain transfer tends to produce branched molecules or crosslinked molecules. Thus, chain transfer offers a way of controlling the molecular weight distribution, crosslink density, thermal properties, and/or mechanical properties of the cured resin composition.

Any suitable chain transfer agent can be employed. For example, the chain transfer agent for a cationic polymerizable component is a hydroxyl-containing compound, such as a compound containing 2 or more than 2 hydroxyl-groups. In an embodiment, the chain transfer agent is selected from the group consisting of a polyether polyol, polyester polyol, polycarbonate polyol, ethoxylated or propoxylated aliphatic or aromatic compounds having hydroxyl groups, dendritic polyols, hyperbranched polyols. An example of a polyether polyol is a polyether polyol comprising an alkoxy ether group of the formula [(CH2)ₙO]ₘ, wherein n can be 1 to 6 and m can be 1 to 100.

A particular example of a chain transfer agent is polytetrahydrofuran such as TERATHANE™.

The photocurable resin composition for additive fabrication can include any suitable amount of the chain transfer agent, for example, in certain embodiments, in an amount up to 50% by weight of the composition, in certain embodiments, up to 30% by weight of
the composition, and in certain other embodiments from 10% to 20% by weight of the composition.

The photocurable resin composition for additive fabrication of the invention can further include one or more additives selected from the group consisting of bubble breakers, antioxidants, surfactants, acid scavengers, pigments, dyes, thickeners, flame retardants, silane coupling agents, ultraviolet absorbers, resin particles, core-shell particle impact modifiers, soluble polymers and block polymers, organic, inorganic, or organic-inorganic hybrid fillers of sizes ranging from 8 nanometers to 50 microns.

Stabilizers are often added to the compositions in order to prevent a viscosity build-up, for instance a viscosity build-up during usage in a solid imaging process. Preferred stabilizers include those described in U.S. Pat. No. 5,665,792. Such stabilizers are usually hydrocarbon carboxylic acid salts of group IA and IIA metals. Most preferred examples of these salts are sodium bicarbonate, potassium bicarbonate, and rubidium carbonate. Rubidium carbonate is preferred for formulations of this invention with recommended amounts varying between 0.0015 to 0.005% by weight of composition. Alternative stabilizers include polyvinylpyrrolidones and polyacrylonitriles. Other possible additives include dyes, pigments, fillers (e.g. silica particles - preferably cylindrical or spherical silica particles - , talc, glass powder, alumina, alumina hydrate, magnesium oxide, magnesium hydroxide, barium sulfate, calcium sulfate, calcium carbonate, magnesium carbonate, silicate mineral, diatomaceous earth, silica sand, silica powder, titanium oxide, aluminum powder, bronze powder, zinc powder, copper powder, lead powder, gold powder, silver dust, glass fiber, titanic acid potassium whisker, carbon whisker, sapphire whisker, beryllia whisker, boron carbide whisker, silicon carbide whisker, silicon nitride whisker, glass beads, hollow glass beads, metaloxides and potassium titanate whisker), antioxidants, wetting agents, photosensitizers for the free-radical photoinitiator, chain transfer agents, leveling agents, defoamers, surfactants and the like.

In accordance with an embodiment of the invention, the photocurable resin composition for additive fabrication contains the polymerizable components such that the desired photosensitivity is obtained by choosing an appropriate ratio of the initiators and/or polymerizable components. The ratio of the components and of the initiators affect the photosensitivity, speed of curing, degree of curing, crosslink density, thermal properties (e.g., Tg), and/or mechanical properties (e.g., tensile strength, storage modulus, loss modulus) of the photocurable resin composition for additive fabrication or of the cured article.

Accordingly, in an embodiment, the ratio by weight of cationic photoinitiator to free-radical photoinitiator (CPI/RPI) is less than 4.0, preferably from 0.1 to 2.0, and more preferably from 0.2 to 1.0.

In accordance with an embodiment, the photocurable resin composition for additive fabrication has a ratio by weight of cationic polymerizable component to free-radical polymerizable component (CPC/RPC) is less than 7.0, or less than 5.0, e.g., from 0.5 to 2.0, and more preferably from 1.0 to 1.5.

In accordance with an embodiment, the photocurable resin composition for additive fabrication is free or substantially free of antimony-containing initiator (less than 1.5% by weight).

The present invention further provides a three-dimensional article comprising a cured photocurable resin composition for additive fabrication, wherein the cured photocurable resin composition for additive fabrication is obtained by curing a photocurable resin composition for additive fabrication by irradiating it with light emitted from a light emitting diode (LED) light having a wavelength from 100 nm to 900 nm.

The present invention further provides a process for making a three-dimensional article comprising the steps of forming and selectively curing a layer of a photocurable resin composition for additive fabrication by irradiation with a light emitting diode (LED) light having a wavelength from 100 nm to 900 nm, the photocurable resin composition and repeating the steps of forming and selectively curing a layer of the photocurable resin composition a plurality of times to obtain the three-dimensional article.

As used herein, the term "renewable resource material" is defined as a starting material that is not derived from petroleum but as a starting material derived from a plant including the fruits, nuts and/or seeds of plants. These plant derived materials are environmentally friendly and biologically based materials. Thus, these starting materials are also frequently called "bio-based" materials or "natural oil" materials.

Further to the understood definition of "bio-based," according to the FRSIA(Farm Security and Rural Investment Act), "biobased products" are products determined by the U.S. Secretary of Agriculture to be "commercial or industrial goods (other than food or feed) composed in whole or in significant part of biological products, forestry materials, or renewable domestic agricultural materials, including plant, animal or marine materials.

Biobased content may be determined by testing to ASTM Method D6866-10, STANDARD TEST METHODS FOR DETERMINING THE BIOBASED CONTENT OF SOLID, LIQUID, AND GASEOUS SAMPLES USING RADIOCARBON ANALYSIS. This method, similar to radiocarbon dating, compares how much of a decaying carbon isotope remains in a sample to how much would be in the same sample if it were made of entirely recently grown materials. The percentage is called the product's biobased content.

Persons of ordinary skill in the art of photocurable resin compositions for additive fabrication are aware of how to select ingredients and understand whether the ingredient is biobased or petroleum based. What is different now is the sheer abundance of bio-based raw materials suitable for use in photocurable resin compositions for additive fabrication. For example, bio-based raw materials can be found in polyols and other ingredients.

In embodiments of the invention, the photocurable resin compositions for additive fabrication comprise at least 30 wt% of bio-based ingredients, rather than petroleum based ingredients. In other embodiments, the photocurable resin compositions for additive fabrication comprise at least 40 wt% of bio-based ingredients, rather than petroleum based ingredients.

The following examples further illustrate the invention but, of course, should not be construed as in any way limiting its scope.

### EXAMPLES 1-56

These examples illustrate embodiments of the photocurable resin compositions for additive fabrication. Tables 1A-1D describe the various components of the photocurable resin compositions for additive fabrication illustrated in Tables 2-7.

**TABLE 1A**

| **Trade Name** | **CAS RN** | **Function in Formula** | **Chemical Descriptor** | **Supplier** |
|---|---|---|---|---|
| 1-pyrenemethanol | 24463-15-8 | Photosensitizing agent | 1-pyrenemethanol | Sigma Aldrich |
| 9-anthracenemethanol | 1468-95-7 | Photosensitizing agent | 9-(Hydroxymethyl)anthracene | Sigma Aldrich |
| NK Ester A-DOG | 87320-05-6 | Free radical polymerizable monomer or oligomer | [2-[1,1-dimethyl-2-[(1-oxoallyl)oxy]ethyl]-5-ethyl-1,3-dioxan-5-yl]methyl acrylate | Kowa |
| Anthracene | 120-12-7 | Photosensitizing agent | Anthracene | Sigma Aldrich |
| Anthracure UVS 1101 | 68818-86-0 | Photosensitizing agent | 9,10-Diethoxy-anthracene, | Kawaski Kasei |
| BYK A 501 | proprietary mixture | Bubble breaker | Naphtha/methoxy propanol acetate | BYK-Chemie |
| CD 406 | 67905-41-3 | Free radical polymerizable monomer or oligomer | 1,4-Cyclohexanedimethanol diacrylate | Sartomer |
| CD 536 | 87320-05-6 | Free radical polymerizable monomer or oligomer | 2-Propenoic acid, [2-[1,1-dimethyl-2-[(1-oxo-2-propenyl)oxy]ethyl]-5-ethyl-1,3-dioxan-S-yl]methyl ester | Sartomer |
| Celloxide 2021P | 25085-98-7; 2386-87-0 | Cationic polymerizable monomer or oligomer | (3',4'-Epoxycyclohexylmethyl) 3,4-epoxycyclohexanecarboxylate | Daicel Chemical |
| Chivacure 1176 | 159120-95-3 (mixture) | Photoacid generator | A mixture of: bis[4-diphenylsulfoniumphenyl]sulfide bishexafluoroantimonate; thiophenoxyphenylsulfonium hexafluoroantimonate and propylene carbonate. | Chitec |
| CHDM | 105-08-8 | Chain transfer agent for cationic monomers | 1,4-Cyclohexanedimethanol | Eastman Chemical |
| Chivacure BMS | 83846-85-9 | Photosensitizing agent | [4-[(4-methylphenyl)thio]phenyl]phenyl-methanone | Chitec |
| Chivacure ITX | 75081-21-9 | Photosensitizing agent | Isopropyl-9H-thioxanthen-9-one | Chitec |

**TABLE 1B**

| **Trade Name** | **CAS RN** | **Function in Formula** | **Chemical Descriptor** | **Supplier** |
|---|---|---|---|---|
| COPIKEM 14 ORANGE | 67697-75-0 | Color change dye | 3-[N,N-bis(4-octylphenyl)amino]-3-(4-dimethylaminophenyl)phthalide | Hilton Davis |
| Darocur 1173 | 7473-98-5 | Free radical generator | 1-Hydroxy-1-methylethyl phenyl ketone | Ciba |
| EBECRYL 3700 | 4687-94-9 | Free radical polymerizable monomer or oligomer | Bisphenol A diglycidyl ether diacrylate | Cytec |
| EPONOX 1510 | 30583-72-3/13410-58-7 | Cationic polymerizable monomer or oligomer | Hydrogenated bisphenol A-epichlorohydrin based epoxy resin | Hexion |
| GRILONIT F713 | 26951-52-0 | Cationic polymerizable monomer or oligomer | Poly(oxy-1,4-butanediyl), a-(oxiranylmethyl)-w-(oxiranylmethoxy)- | EMS |
| Irgacure PAG 290 (GSID 4480-1) | Not known | Photoacid generator | tris(4-(4-acetylphenyl)thiophenyl)sulfonium tetrakis(pentafluorophenyl)borate | Ciba/BASF |
| Heloxy 107 | 14228-73-0 | Cationic polymerizable monomer or oligomer | 1,4-Cyclohexanedimethanol diglycidyl ether | Hexion |
| Intermediate DG-0049 | proprietary mixture | Pigment dispersion for color effects | Pigment dispersion for color effects | Desotech |
| Irgacure 184 | 947-19-3 | Free radical generator | 1-Hydroxy-1-cyclohexyl phenyl ketone | Ciba |
| IRGANOX 1035 | 41484-35-9 | Antioxidant | Benzenepropanoic acid, 3,5-bis(1,1-dimethylethyl)-4-hydroxy-, thiodi-2,1-ethanediyl ester | Ciba |
| Kayarad R 684 | 42594-17-2 | Free radical polymerizable monomer or oligomer | Dicyclopentadienedimethanol diacrylate | Nippon Kayaku |

**TABLE 1C**

| **Trade Name** | **CAS RN** | **Function in Formula** | **Chemical Descriptor** | **Supplier** |
|---|---|---|---|---|
| Longnox 10 | 6683-19-8 | Antioxidant | Pentaerythritol tetrakis[(3,5-di-tert-butyl-4-hydroxyphenyl)propionate] | Longchem C&S Int. |
| Orange Pigment | proprietary mixture | Pigment dispersion for color effects | | Desotech |
| OXT-101 | 3047-32-3 | Cationic polymerizable monomer or oligomer | 3-Ethyl-3-oxetanemethanol | Toagosei |
| OXT-121 | 142627-97-2 | Cationic polymerizable monomer or oligomer | 1,4-Bis[(3-ethyl-3-oxetanylmethoxy)methyl]benzene | Toagosei |
| OXT-221 | 18934-00-4 | Cationic polymerizable monomer or oligomer | 3,3'-[Oxybis(methylene)]bis[3-ethyl-oxetane | Toagosei |
| Polyvinyl pyrrolidone | 9003-39-8 | Acid scavenger | Poly[N-vinylpyrrolidinone]; PVP | Sigma Aldrich |
| Red Pigment | proprietary mixture | Pigment dispersion for color effects | | Desotech |
| Rhodorsil 2074 | 178233-72-2 | Photoacid generator | Iodonium, [4-(1-methylethyl)phenyl](4-methylphenyl)-, tetrakis(pentafluorophenyl)borate | Rhodia |
| Rubidium carbonate | 584-09-8 | Acid scavenger | Dirubidium carbonate; Rb2CO3 | Sigma Aldrich |
| Silwet L 7600 | mixture | Leveling agent | Polyalkyleneoxide modified polydimethylsiloxane | Momentive |
| SR 399 | 60506-81-2 | Free radical polymerizable monomer or oligomer | Dipentaerythritol monohydroxypentaacrylate | Sartomer |
| SR 492 | 53879-54-2 | Free radical polymerizable monomer or oligomer | Propoxylated trimethylolpropane triacrylate | Sartomer |

**TABLE 1D**

| **Trade Name** | **CAS RN** | **Function in Formula** | **Chemical Descriptor** | **Supplier** |
|---|---|---|---|---|
| SR 9003 | 84170-74-1 | Free radical polymerizable monomer or oligomer | Propoxylated neopentyl glycol diacrylate | Sartomer |
| TERATHANE 1000 | 25190-06-1 | Chain transfer agent for cationic monomers | Poly(tetramethylene ether) glycol | Invista |
| VEctomer® VE 4010 | 130066-57-8 | Cationic polymerizable monomer or oligomer | Bis(4-vinyloxybutyl) isophthalate | Vertellus |
| VEctomer® VE 5015 | 196109-17-8 | Cationic polymerizable monomer or oligomer | Tris[4-(vinyloxy)butyl] trimellitate | Vertellus |

**TABLE 2**

| **Composition** | Example 1 | Example 2 | Example 3 | Example 4 | Example 5 | Example 6 | Example 7 | Example 8 | Example 9 |
|---|---|---|---|---|---|---|---|---|---|
| Name | Part | Part | Part | Part | Part | Part | Part | Part | Part |
| EBECRYL-3700 | 25.000 | 19.659 | 19.659 | 19.659 | 19.659 | 25.000 | 25.000 | 25.000 | 24.611 |
| CD 406 | 7.000 | | | | | 7.000 | 7.000 | 7.000 | |
| Kayarad R 684 | | | | | | | | | 6.891 |
| Kowa A-DOG | | | | | | | | | |
| SR492 | | | | | | | | | |
| VEctomer® VE 5015 | | | | | | | | | |
| VEctomer® VE 4010 | | | | | | | | | |
| Celloxide 2021P | 36.000 | 54.040 | 54.04 | 54.04 | 54.04 | 43.910 | 41.620 | 39.215 | 42.034 |
| OXT-101 | | 8.603 | 8.603 | 8.603 | 8.603 | | | | |
| OXT-221 | | | | | | | | | |
| OXT-121 | | | | | | | | | |
| TERATHANE-1000 | 25.000 | 10.463 | 10.463 | 10.463 | 10.463 | 17.085 | 19.375 | 21.780 | 19.568 |
| Chivacure 1176 | | | | | | | | | |
| GSID4480-1 CPI | 4.000 | | | | | | | | |
| Rhodorsil 2074 | | 0.750 | 1 | 1.5 | 2 | 2.000 | 2.000 | 2.000 | 1.969 |
| Irgacure 184 | 3.000 | 4.259 | 4.005 | 3.5025 | 3 | 3.000 | 3.000 | 3.000 | 2.953 |
| Darocur 1173 | | | | | | | | | |
| Chivacure BMS | | 2.000 | 2 | 2 | 2 | 2.000 | 2.000 | 2.000 | 1.969 |
| Chivacure ITX | | | | | | | | | |
| 1-pyrenemethanol 9-anthracenemethanol | | | | | | | | | |
| | | | | | | | | | |
| Anthracure UVS 1101 | | | | | | | | | |
| Longnox 10 | | 0.001 | 0.005 | 0.0075 | 0.01 | | | | |
| PVP | | 0.005 | 0.005 | 0.005 | 0.005 | 0.005 | 0.005 | 0.005 | 0.005 |
| Rubidium carbonate | | | | | | | | | |
| Silwet L 7600 | | 0.200 | 0.2 | 0.2 | 0.2 | | | | |
| BYK A 501 | | 0.020 | 0.02 | 0.02 | 0.02 | | | | |
| Total | 100.000 | 100.000 | 100.000 | 100.000 | 100.000 | 100.000 | 100.000 | 100.000 | 100.000 |

**TABLE 3**

| **Composition** | Example 10 | Example 11 | Example 12 | Example 13 | Example 14 | Example 15 | Example 16 | Example 17 | Example 18 |
|---|---|---|---|---|---|---|---|---|---|
| Name | Part | Part | Part | Part | Part | Part | Part | Part | Part |
| EBECRYL-3700 | 25.000 | 25.000 | 25.000 | | | | 32.000 | | |
| CD 406 | 7.000 | 7.000 | 7.000 | | | | | | |
| Kayarad R 684 | | | | 32.000 | 16.000 | | | 32.000 | 16.000 |
| Kowa A-DOG | | | | | 16.000 | 32.000 | | 0.000 | 16.000 |
| SR492 | | | | | | | | | |
| VEctomer® VE 5015 | | | | | | | | | |
| VEctomer® VE 4010 | | | | | | | | | |
| Celloxide 2021P | 42.698 | 46.920 | 49.570 | 46.920 | 46.920 | 41.055 | 41.055 | 41.055 | 41.055 |
| OXT-101 | | | | | | 6.212 | 6.212 | 6.212 | 6.212 |
| OXT-221 | | | | | | | | | |
| OXT-121 | | | | | | | | | |
| TERATHANE-1000 | 19.877 | 14.075 | 11.425 | 14.075 | 14.075 | 10.948 | 10.948 | 10.948 | 10.948 |
| Chivacure 1176 | | | | | | | | | |
| GSID4480-1 CPI | | | | | | | | | |
| Rhodorsil 2074 | 2.000 | 2.000 | 2.000 | 2.000 | 2.000 | 1.553 | 1.553 | 1.553 | 1.553 |
| Irgacure 184 | 3.000 | 3.000 | 3.000 | 3.000 | 3.000 | 6.213 | 6.213 | 6.213 | 6.213 |
| Darocur 1173 | | | | | | | | | |
| Chivacure BMS | | 2.000 | 2.000 | 2.000 | 2.000 | 1.553 | 1.553 | 1.553 | 1.553 |
| Chivacure ITX | 0.420 | | | | | | | | |
| 1-pyrenemethanol | | | | | | | | | |
| 9-anthracenemethanol | | | | | | | | | |
| Anthracure UVS 1101 | | | | | | | | | |
| Longnox 10 | | | | | | 0.116 | 0.116 | 0.116 | 0.116 |
| PVP | 0.005 | 0.005 | 0.005 | 0.005 | 0.005 | 0.008 | 0.008 | 0.008 | 0.008 |
| Rubidium carbonate | | | | | | | | | |
| Silwet L 7600 | | | | | | 0.311 | 0.311 | 0.311 | 0.311 |
| BYK A 501 | | | | | | 0.031 | 0.031 | 0.031 | 0.031 |
| Total | 100.000 | 100.000 | 100.000 | 100.000 | 100.000 | 100.000 | 100.000 | 100.000 | 100.000 |

**TABLE 4**

| **Composition** | Example 19 | Example 20 | Example 21 | Example 22 | Example 23 | Example 24 | Example 25 | Example 26 | Example 27 |
|---|---|---|---|---|---|---|---|---|---|
| Name | Part | Part | Part | Part | Part | Part | Part | Part | Part |
| EBECRYL-3700 | | | | | | | | | |
| CD 406 | | | | | | | | | |
| Kayarad R 684 | 29.009 | | 29.009 | 48.102 | | | | | |
| Kowa A-DOG | | 28.510 | | | | | | | |
| SR492 | | | | | | | | | |
| VEctomer® VE 5015 | | | | | | | | | 38.000 |
| VEctomer® VE 4010 | | | 35.726 | 24.208 | | | | 52.780 | |
| Celloxide 2021P | 33.018 | 33.018 | 25.045 | 16.970 | 89.280 | 48.780 | 40.000 | 37.000 | 28.330 |
| OXT-101 | 3.995 | 3.995 | 3.995 | 3.995 | 3.995 | 3.995 | 3.995 | 3.995 | 3.995 |
| OXT-221 | 27.752 | 27.752 | | | | 41.000 | | | 24.200 |
| OXT-121 | | | | | | | 50.530 | | |
| TERATHANE-1000 | | | | | | | | | |
| Chivacure 1176 | | | | | | | | | |
| GSID4480-1 CPI | | | | | | | | | |
| Rhodorsil 2074 | 1.000 | 1.000 | 1.000 | 1.000 | 1.000 | 1.000 | 1.000 | 1.000 | 1.000 |
| Irgacure 184 | 4.000 | 4.000 | 4.000 | | 4.000 | 4.000 | 4.000 | 4.000 | |
| Darocur 1173 | | | | 4.000 | | | | | 4.000 |
| Chivacure BMS | 1.000 | 1.500 | 1.000 | 1.500 | 1.500 | 1.000 | | 1.000 | |
| Chivacure ITX | | | | | | | 0.250 | | 0.250 |
| 1-pyrenemethanol | | | | | | | | | |
| 9-anthracenemethanol | | | | | | | | | |
| Anthracure UVS 1101 | | | | | | | | | |
| Longnox 10 | 0.005 | 0.005 | 0.005 | 0.005 | 0.005 | 0.005 | 0.005 | 0.005 | 0.005 |
| PVP | | | | | | | | | |
| Rubidium carbonate | | | | | | | | | |
| Silwet L 7600 | 0.200 | 0.200 | 0.200 | 0.200 | 0.200 | 0.200 | 0.200 | 0.200 | 0.200 |
| BYK A 501 | 0.020 | 0.020 | 0.020 | 0.020 | 0.020 | 0.020 | 0.020 | 0.020 | 0.020 |
| Total | 100.000 | 100.000 | 100.000 | 100.000 | 100.000 | 100.000 | 100.000 | 100.000 | 100.000 |

**TABLE 5**

| **Composition** | Example 28 | Example 29 | Example 30 | Example 31 | Example 32 | Example 33 | Example 34 | Example 35 | Example 36 |
|---|---|---|---|---|---|---|---|---|---|
| Name | Part | Part | Part | Part | Part | Part | Part | Part | Part |
| EBECRYL-3700 | | | | 17.343 | 24.936 | 24.924 | 17.536 | 17.237 | 24.449 |
| CD 406 | | | | | 6.982 | 6.979 | | | 6.846 |
| Kayarad R 684 | 32.796 | 56.22 | | | | | | | |
| Kowa A-DOG | | | 32.796 | | | | | | |
| SR492 | 23.424 | | 23.424 | | | | | | |
| VEctomer® VE 5015 | | | | | | | | | |
| VEctomer® VE 4010 | | | | | | | | | |
| Celloxide 2021 P | 26.432 | 26.432 | 26.432 | 53.283 | 35.01 | 34.993 | 53.878 | 52.959 | 34.326 |
| OXT-101 | 3.999 | 3.999 | 3.999 | 8.483 | | | 8.577 | 8.431 | |
| OXT-221 | | | | | | | | | |
| OXT-121 | | | | | | | | | |
| TERATHANE-1000 | 7.049 | 7.049 | 7.049 | 10.317 | 24.936 | 24.924 | 10.432 | 10.254 | 24.449 |
| Chivacure 1176 | | | | 4.023 | 3.391 | 3.39 | 4.068 | 3.998 | 3.325 |
| GSID4480-1 CPI | | | | | | | | 2 | 2.2 |
| Rhodorsil 2074 | 1 | | | | | | | | |
| Irgacure 184 | 4 | 4 | 4 | 4.93 | 4.489 | 4.486 | 4.985 | 4.9 | 4.401 |
| Chivacure BMS | 1 | 1 | 1 | | | | | | |
| 1-pyrenemethano | | | | 1.4 | | | | | |
| 9-anthracenemethanol | | | | | 0.25 | | | | |
| Anthracure UVS 1101 | | | | | | 0.3 | 0.3 | | |
| Longnox 10 | 0.075 | 0.075 | 0.075 | | | | | | |
| PVP | 0.005 | 0.005 | 0.005 | 0.005 | | | 0.005 | 0.005 | |
| Rubidium carbonate | | | | | 0.005 | 0.005 | | | 0.005 |
| Silwet L 7600 | 0.2 | 0.2 | 0.2 | 0.197 | | | 0.199 | 0.196 | |
| BYK A 501 | 0.02 | 0.02 | 0.02 | 0.02 | | | 0.02 | 0.02 | |
| Total | 100 | 100 | 100 | 100 | 100 | 100 | 100 | 100 | 100 |

**TABLE 6**

| **Composition** | Example 37 | Example 38 | Example 39 | Example 40 | Example 41 | Example 42 | Example 43 | Example 44 | Example 45 | Example 46 |
|---|---|---|---|---|---|---|---|---|---|---|
| Component | Part | Part | Part | Part | Part | Part | Part | Part | Part | Part |
| Ebecryl 3700 | 25.000 | | | | 16.000 | | | | | |
| SR 399 | | | | | | 6.353 | 7.000 | 6.353 | 8.198 | 8.216 |
| Sartomer 9003 | | | | | | | | | 4.099 | 4.108 |
| CD 406 | 7.000 | | | | | | | | | |
| Kayarad R 684 | | 16.000 | 32.000 | | | 25.647 | | 25.647 | | |
| Kowa A-DOG | | 16.000 | | 32.000 | 16.000 | | 25.000 | | | |
| Epon 1510 | 43.990 | 43.990 | 43.990 | 43.990 | 43.990 | 43.990 | 43.990 | | 63.003 | 63.142 |
| Heloxy 107 | | | | | | | | 43.990 | | |
| OXT-101 | 16.000 | 16.000 | 16.000 | 16.000 | 16.000 | 16.000 | 16.000 | 16.000 | 16.957 | 16.994 |
| Chivacure 1176 | | | | | | | | | | |
| Rhodorsil PI 2074 | 2.000 | 2.000 | 2.000 | 2.000 | 2.000 | 2.000 | 2.000 | 2.000 | 2.000 | 2.004 |
| 1-Pyrenemethanol | | | | | | | | | | |
| 9-Anthracenemethanol | | | | | | | | | | |
| Anthracure UVS 1101 | | | | | | | | | | |
| Anthracene | | | | | | | | | | |
| Irgacure 184 | 4.000 | 4.000 | 4.000 | 4.000 | 4.000 | 4.000 | 4.000 | 4.000 | 2.799 | 2.806 |
| Darocur 1173 | | | | | | | | | | |
| Chivacure BMS | 2.000 | 2.000 | 2.000 | 2.000 | 2.000 | 2.000 | 2.000 | 2.000 | 2.000 | 2.004 |
| Longnox 10 | 0.010 | 0.010 | 0.010 | 0.010 | 0.010 | 0.010 | 0.010 | 0.010 | 0.500 | 0.501 |
| Polyvinyl pyrrolidone | | | | | | | | | 0.005 | 0.005 |
| Silwet L7600 | | | | | | | | | 0.200 | 0.200 |
| BYK A501 | | | | | | | | | 0.020 | 0.020 |
| Intermediate DG-0049 | | | | | | | | | 0.220 | |
| Total | 100.000 | 100.000 | 100.000 | 100.000 | 100.000 | 100.000 | 100.000 | 100.000 | 100.000 | 100.000 |

**TABLE 7**

| **Composition** | Example 47 | Example 48 | Example 49 | Example 50 | Example 51 | Example 52 | Example 53 | Example 54 | Example 55 | Example 56 |
|---|---|---|---|---|---|---|---|---|---|---|
| Component | Part | Part | Part | Part | Part | Part | Part | Part | Part | Part |
| Ebecryl 3700 | | | | | | | | | | |
| SR 399 | 8.292 | 8.292 | 8.292 | 8.292 | 8.292 | 7.822 | 7.905 | 7.909 | 7.909 | 8.014 |
| Sartomer 9003 | 4.147 | 4.147 | 4.147 | 4.147 | 4.147 | 3.911 | 3.953 | 3.955 | 3.955 | 4.007 |
| CD 406 | | | | | | | | | | |
| Kayarad R 684 | | | | | | | | | | |
| Kowa A-DOG | | | | | | | | | | |
| Epon 1510 | 64.051 | 64.051 | 64.051 | 64.051 | 64.051 | 60.420 | 61.064 | 61.094 | 61.094 | 62.266 |
| Heloxy 107 | | | | | | | | | | |
| OXT-101 | 17.191 | 17.191 | 17.191 | 17.191 | 17.191 | 16.217 | 16.389 | 16.398 | 16.398 | 16.555 |
| Chivacure 1176 | | | | | | 4.831 | 4.883 | 4.885 | 4.885 | 1.547 |
| Rhodorsil PI 2074 | 1.545 | 2.045 | 2.045 | 1.045 | 1.045 | | | | | 0.516 |
| 1-Pyrenemethanol | | | | | | 1.400 | | | | |
| 9-Anthracenemethanol | | | | | | | 0.350 | | | 0.350 |
| Anthracure UVS 1101 | | | | | | | | 0.300 | | |
| Anthracene | | | | | | | | | 0.300 | |
| Irgacure 184 | 1.75 | 0.5 | 2 | 1.5 | 3 | 3.747 | 3.787 | 3.789 | 3.789 | 1.200 |
| Darocur 1173 | | | | | | | | | | 4.000 |
| Chivacure BMS | 1.273 | 2.023 | 0.523 | 2.023 | 0.523 | | | | | |
| Longnox 10 | 1.307 | 1.307 | 1.307 | 1.307 | 1.307 | 1.233 | 1.246 | 1.246 | 1.246 | 1.255 |
| Polyvinyl pyrrolidone | 0.005 | 0.005 | 0.005 | 0.005 | 0.005 | 0.005 | 0.005 | 0.005 | 0.005 | 0.005 |
| Silwet L7600 | 0.209 | 0.209 | 0.209 | 0.209 | 0.209 | 0.197 | 0.199 | 0.199 | 0.199 | 0.201 |
| BYK A501 | 0.021 | 0.021 | 0.021 | 0.021 | 0.021 | 0.020 | 0.020 | 0.020 | 0.020 | 0.020 |
| Intermediate DG-0049 | 0.209 | 0.209 | 0.209 | 0.209 | 0.209 | 0.197 | 0.199 | 0.199 | 0.199 | 0.063 |
| Total | 100.000 | 100.000 | 100.000 | 100.000 | 100.000 | 100.000 | 100.000 | 100.000 | 100.000 | 100.000 |

### EXAMPLE 57

This Example illustrates some of the properties of the photocurable resin composition for additive fabrication embodiments set forth in Examples 1-56. Tables 8-26 set forth the Dp, Ec, and E3-E5 values and Table 27 sets forth the CPI/RPI and CPC/RPC values.

The photosensitivity of the compositions are evaluated by measuring Critical Energy (Ec) values, Depth of Penetration (Dp) values, and Storage Shear Modulus (G') upon exposure to curing light. The Ec and Dp values are measured using a photo cure speed test using LED light (365 nm). The G' values were measured using a StressTech Rheometer manufactured by Reologicia Instruments AB, Sweden. Each of the methods are summarized below.

The photo cure speed test using 365 nm LED light is used to measure values for Ec and Dp. A single UV LED "bare bulb" (Model No. NCSUO33A; Nichia Corporation, Japan) having a peak wavelength of 365 nm is used as the LED light source in a light curing apparatus, wherein the single LED light is bottom-mounted on a flat surface inside a 30 °C chamber and positioned in an upward-looking arrangement and pointing vertically. The LED light is powered by a 3.30 V / 0.050 A DC output from a Programmable Power Supply (Model No. PSS-3203; GW Instek).

A 25 µm (10-mil) sheet of polyester film (Melinex #515, Polybase Mylar D, 0.0025 µm (0.010 gauge)) is placed at a distance of 12 mm above from the bottom of the LED light bulb. A drop of the liquid resin is placed on the polyester film over the center of the LED light. The resin is exposed to the LED light through the polyester film for a specific time interval. The process is repeated with fresh resin for 2, 4, 6, 8, 10 second exposure times or up to 12, 16, or 20 seconds for slow curing resin formulations.

After exposure to the LED light, the sample is allowed to age inside the 30 °C chamber for at least 15 minutes, after which time any uncured resin is removed from the exposed areas by blotting with a Kimwipe EX-L (Kimberly Clark). A thickness measurement is then taken on the center of the exposed area using an ABSOLUTE Digimatic Indicator (Model ID- Cl 12CE, Mitutoyo Corporation, Japan). The measured thickness of each sample is plotted as a function of the natural logarithm of the exposure time. The depth of penetration (Dp; mil) of the resin composition is the slope of the least squares fit line. The
Ec (sec) is the X-axis crossing point (Y=0) of the line. The E3, E₄, or E₅ is, respectively, the time (in seconds) required to produce a layer having a thickness of 8 × 10¹, 1 × 10², or 1 × 10² µm (3, 4, or 5 mils), respectively.

Alternatively, when the intensity of the incident light (mW/cm²) from the light source on the resin surface is known, the exposure energy (mJ/cm²) rather than the exposure time (in seconds) is used for calculating the Dp and Ec values.

The tensile properties (tensile strength, percent elongation at break, and modulus) of cured samples of the photocurable resin compositions for additive fabrication are tested on films, where applicable, using a universal testing instrument, Instron Model 4201 equipped with a suitable personal computer and Instron software to yield values of tensile strength, percent elongation at break, and elastic modulus. The tensile test is performed on the Instron with a crosshead speed of 2.54 cm/min (1.00 inch/min) and a crosshead jaw separation of 5.08 cm (2.00 inches) in a 50% relative humidity room at room temperature. Samples are prepared for testing by curing the liquid resin composition applied on Mylar (0.003 µm (0.01 gauge)) with a 1 × 10² µm (5 mil) square draw bar, and cured on an unfiltered Fusion D bulb (600W) in nitrogen with an exposure of 300 mJ/cm². The cured film samples were cut within 1 hour of cure to have 1 × 1·10¹ cm (0.5 x 4") strips and conditioned in a 50% relative humidity room at RT for 24 hours before the tensile test was performed. Tensile test data was not performed for Examples 1-5, 13-27, 31-36, and 45-56.

### Real Time Dynamic Mechanical Analysis (RT-DMA^

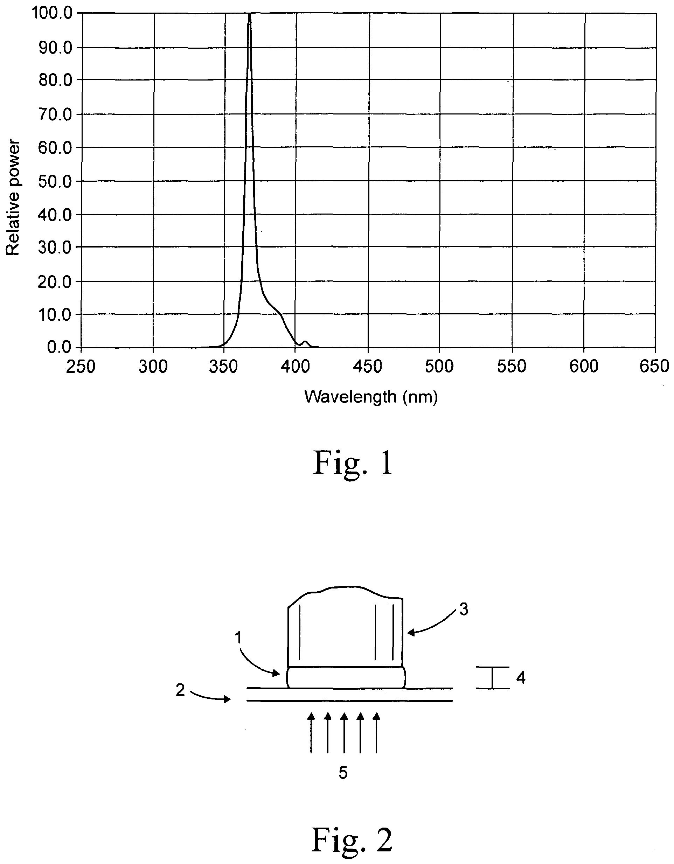

Real Time Dynamic Mechanical Analysis (RT-DMA), including the storage shear modulus (G'), is carried out under ambient lab conditions (20-23 °C and 25-35% RH), on compositions undergoing curing using a StressTech Rheometer (Reologicia Instruments AB, Sweden) with an 8 mm plate, a gap of 0.1 mm or 0.05 mm, as specified in the Tables 15-23, and modified to include a mercury lamp light source (OMNICURE Series 2000 available from EXFO), fitted with a 365 nm interference filter (also available from EXFO) placed in the light path and a liquid-filled light guide for conveying light from the source to the rheometer. The 365 nm interference filter produces the spectral output shown in Figure 1. The samples are evaluated under the following parameters: 10 s of equilibrium time; frequency of 10 Hz; 44-50 mW/cm2 light intensity (as specified in the Tables 15-23) by the IL 1400 radiometer with XRL140B detector (International Light, Newburyport, MA); 1.0 s exposure that starts at 2.1 seconds from the beginning of data collection; FFT smoothing of curves; G' taken at 2.5, 2.7, 3,4, and 6 s from the beginning of data collection by using the accompanying software for data analysis.

Figure 2 shows a schematic of the RT-DMA apparatus. The photocurable resin composition (1) is placed on a plane (2). The amount of liquid resin used should be approximately the amount indicated in the figure. The plane is a quartz plate that is sold with the StressTech Rheometer. The 8 mm plate (3) is positioned with a 0.1 mm gap (4) between the plate and the plane. The gap is set via the software accompanying the StressTech Rheometer. Light (5) is provided though the plane (2). Please see the publication "Dynamic Mechanical Analysis of UV-Curable Coatings While Curing" by Robert W. Johnson available at http://reologicainstruments.com/PDF%20files/BobJohnsonUVpaper.pdf, for more information on RT-DMA. G' data was not measured for Examples 45-56.

**TABLE 8**

| | Example 1 | Example 2 | Example 3 | Example 4 | Example 5 | Example 6 | Example 7 | Example 8 | Example 9 |
|---|---|---|---|---|---|---|---|---|---|
| | | | | | | | | | |
| Dp (mil) | 3.53 | 2.72 | 2.73 | 2.62 | 2.78 | 2.79 | 2.95 | 2.91 | 2.78 |
| Ec (s) | 1.13 | 1.27 | 0.94 | 0.81 | 0.97 | 0.77 | 0.70 | 0.71 | 1.00 |
| E3 (s) | 2.64 | 3.81 | 2.83 | 2.53 | 2.85 | 2.27 | 1.93 | 2.00 | 2.95 |
| E4 (s) | 3.50 | 5.50 | 4.08 | 3.71 | 4.09 | 3.25 | 2.71 | 2.82 | 4.24 |
| E5 (s) | 4.65 | 7.95 | 5.88 | 5.43 | 5.85 | 4.65 | 3.80 | 3.98 | 6.07 |

**TABLE 9**

| | Example 10 | Example 11 | Example 12 | Example 13 | Example 14 | Example 15 | Example 16 | Example 17 | Example 18 |
|---|---|---|---|---|---|---|---|---|---|
| | | | | | | | | | |
| Dp (mil) | 1.85 | 2.60 | 2.66 | 3.37 | 3.40 | 3.99 | 3.39 | 3.75 | 3.50 |
| Ec (s) | 0.36 | 0.75 | 0.80 | 0.84 | 0.77 | 0.82 | 0.72 | 0.75 | 0.68 |
| E3 (s) | 1.79 | 2.38 | 2.48 | 2.04 | 1.87 | 1.74 | 1.75 | 1.67 | 1.60 |
| E4 (s) | 3.08 | 3.50 | 3.61 | 2.75 | 2.51 | 2.23 | 2.34 | 2.18 | 2.13 |
| E5 (s) | 5.28 | 5.15 | 5.26 | 3.70 | 3.36 | 2.87 | 3.15 | 2.85 | 2.83 |

**TABLE 10**

| | Example 19 | Example 20 | Example 21 | Example 22 | Example 23 | Example 24 | Example 25 | Example 26 | Example 27 |
|---|---|---|---|---|---|---|---|---|---|
| | | | | | | | | | |
| Dp (mil) | 5.79 | 4.59 | 7.12 | 4.96 | 3.32 | 6.70 | 4.19 | 5.90 | 4.40 |
| Ec (s) | 0.92 | 0.69 | 0.80 | 0.82 | 1.33 | 0.91 | 0.69 | 1.18 | 1.23 |
| E3 (s) | 1.55 | 1.34 | 1.22 | 1.50 | 3.27 | 1.43 | 1.41 | 1.97 | 2.44 |
| E4 (s) | 1.84 | 1.66 | 1.40 | 1.84 | 4.42 | 1.66 | 1.79 | 2.33 | 3.07 |
| E5 (s) | 2.18 | 2.06 | 1.61 | 2.25 | 5.98 | 1.93 | 2.27 | 2.76 | 3.85 |

**TABLE 11**

| | Example 28 | Example 29 | Example 30 | Example 31 | Example 32 | Example 33 | Example 34 | Example 35 | Example 36 |
|---|---|---|---|---|---|---|---|---|---|
| | | | | | | | | | |
| Dp (mil) | 5.98 | 6.84 | 6.47 | 1.95 | 1.63 | 2.23 | 2.33 | 5.69 | 5.42 |
| Ec (s) | 1.06 | 1.36 | 1.30 | 0.63 | 1.69 | 0.98 | 1.04 | 1.15 | 1.22 |
| E3 (s) | 1.75 | 2.10 | 2.06 | 2.92 | 10.66 | 3.78 | 3.77 | 1.96 | 2.13 |
| E4 (s) | 2.07 | 2.43 | 2.41 | 4.88 | 19.71 | 5.92 | 5.79 | 2.33 | 2.56 |
| E5 (s) | 2.45 | 2.82 | 2.81 | 8.14 | 36.43 | 9.27 | 8.89 | 2.78 | 3.08 |

**TABLE 12**

| | Example 37 | Example 38 | Example 39 | Example 40 | Example 41 | Example 42 |
|---|---|---|---|---|---|---|
| Dp (mil) | 2.44 | 3.64 | 3.38 | 3.87 | 2.88 | 3.60 |
| Ec (s) | 0.62 | 0.77 | 0.73 | 0.74 | 0.76 | 0.75 |
| E3 (s) | 2.11 | 1.76 | 1.78 | 1.61 | 2.16 | 1.72 |
| E4 (s) | 3.17 | 2.31 | 2.39 | 2.09 | 3.05 | 2.28 |
| E5 (s) | 4.78 | 3.04 | 3.22 | 2.70 | 4.32 | 3.01 |

**TABLE 13**

| | Example 43 | Example 44 | Example 45 | Example 46 | Example 47 | Example 48 | Example 49 | Example 50 |
|---|---|---|---|---|---|---|---|---|
| Dp (mil) | 4.05 | 3.38 | 2.83 | 2.89 | 4.15 | 3.01 | 9.04 | 2.80 |
| Ec (s) | 0.77 | 0.59 | 0.88 | 0.91 | 1.39 | 1.19 | 2.00 | 1.19 |
| E3 (s) | 1.62 | 1.44 | 2.53 | 2.57 | 2.86 | 3.24 | 2.79 | 3.47 |
| E4 (s) | 2.08 | 1.94 | 3.59 | 3.63 | 3.63 | 4.52 | 3.12 | 4.96 |
| E5 (s) | 2.66 | 2.61 | 5.12 | 5.13 | 4.62 | 6.30 | 3.48 | 7.08 |

**TABLE 14**

| | Example 51 | Example 52 | Example 53 | Example 54 | Example 55 | Example 56 |
|---|---|---|---|---|---|---|
| Dp (mil) | 7.62 | 3.09 | 2.38 | 2.47 | 3.32 | 2.86 |
| Ec (s) | 1.69 | 2.36 | 4.34 | 1.81 | 5.31 | 5.57 |
| E3 (s) | 2.51 | 6.22 | 15.31 | 6.09 | 13.12 | 15.92 |
| E4 (s) | 2.86 | 8.59 | 23.31 | 9.12 | 17.74 | 22.59 |
| E5 (s) | 3.26 | 11.87 | 35.48 | 13.67 | 23.97 | 32.04 |

**TABLE 15**

| **Time** (**sec**) | **Storage shear modulus (G'; Pa)** 50 mW/cm²/l sec exposure; 0.10 mm gap | | | | |
|---|---|---|---|---|---|
| Seconds after light on | Example 1 | Example 2 | Example 3 | Example 4 | Example 5 |
| 0.4 | 1.27E+03 | 1.43E+03 | 1.58E+03 | 7.70E+02 | 1.23E+03 |
| 0.6 | 5.51E+03 | 1.23E+03 | 4.40E+03 | 1.33E+03 | 2.87E+03 |
| 0.9 | 1.19E+05 | 1.79E+04 | 6.75E+04 | 3.81E+04 | 5.74E+04 |
| 1.9 | 6.27E+05 | 1.21E+05 | 2.25E+05 | 2.25E+05 | 2.26E+05 |
| 3.9 | 1.03E+06 | 1.74E+05 | 3.46E+05 | 3.74E+05 | 3.91E+05 |

**TABLE 16**

| **Time** (**sec**) | **Storage shear modulus (G'; Pa)** 44 mW/cm²/l sec exposure; 0.05 mm gap | | | | |
|---|---|---|---|---|---|
| Seconds after light on | Example 6 | Example 7 | Example 8 | Example 9 | Example 10 |
| 0.4 | 3.10E+02 | 3.10E+02 | 1.99E+05 | 3.10E+02 | 2.45E+04 |
| 0.6 | 1.98E+04 | 1.61E+04 | 5.43E+05 | 1.61E+04 | 2.14E+05 |
| 0.9 | 2.23E+05 | 2.23E+05 | 1.34E+06 | 2.23E+05 | 8.33E+05 |
| 1.9 | 9.38E+05 | 9.38E+05 | 2.41E+06 | 9.38E+05 | 1.65E+06 |
| 3.9 | 1.47E+06 | 1.46E+06 | 4.16E+06 | 1.48E+06 | 2.74E+06 |

**TABLE 17**

| **Time** (**sec**) | **Storage shear modulus (G'; Pa)** 44 mW/cm²/l sec exposure; 0.10 mm gap | | | |
|---|---|---|---|---|
| Seconds after light on | Example 11 | Example 12 | Example 13 | Example 14 |
| 0.4 | 7.67E+02 | 8.70E+02 | 2.74E+03 | 7.87E+02 |
| 0.6 | 5.27E+02 | 1.02E+03 | 7.15E+03 | 5.83E+03 |
| 0.9 | 3.08E+04 | 2.66E+04 | 8.01E+04 | 1.34E+05 |
| 1.9 | 2.48E+05 | 2.18E+05 | 3.86E+05 | 7.53E+05 |
| 3.9 | 3.57E+05 | 3.05E+05 | 6.58E+05 | 1.41E+06 |

**TABLE 18**

| **Time** (**sec**) | **Storage shear modulus (G'; Pa)** 44 mW/cm²/l sec exposure; 0.10 mm gap | | | |
|---|---|---|---|---|
| Seconds after light on | Example 15 | Example 16 | Example 17 | Example 18 |
| 0.4 | 1.82E+03 | 1.03E+03 | 2.87E+03 | 8.24E+03 |
| 0.6 | 7.70E+04 | 2.13E+04 | 3.17E+04 | 7.29E+04 |
| 0.9 | 5.61E+05 | 2.48E+05 | 2.57E+05 | 3.71E+05 |
| 1.9 | 2.40E+06 | 7.92E+05 | 1.02E+06 | 1.30E+06 |
| 3.9 | 3.90E+06 | 1.17E+06 | 1.59E+06 | 2.04E+06 |

**TABLE 19**

| **Storage shear modulus (G'; Pa)** 47 mW/cm²/l sec exposure; 0.10 mm gap | | | | |
|---|---|---|---|---|
| Example 19 | Example 20 | Example 21 | Example 22 | Example 23 |
| 2.53E+03 | 1.59E+04 | 8.35E+04 | 3.97E+04 | 1.66E+03 |
| 2.14E+04 | 1.03E+04 | 4.30E+05 | 3.19E+05 | 1.66E+03 |
| 1.87E+05 | 8.46E+04 | 1.10E+06 | 1.36E+06 | 1.66E+03 |
| 6.75E+05 | 2.71E+05 | 2.55E+06 | 3.93E+06 | 1.66E+03 |
| 1.05E+06 | 4.23E+05 | 2.96E+06 | 5.41E+06 | 1.66E+03 |

**TABLE 20**

| **Time** (**sec**) | **Storage shear modulus (G'; Pa**) 47 mW/cm²/l sec exposure; 0.10 mm gap | | | | | | |
|---|---|---|---|---|---|---|---|
| Seconds after light on | Example 24 | Example 25 | Example 26 | Example 27 | Example 28 | Example 29 | Example 30 |
| 0.4 | 1.47E+03 | 1.75E+03 | 1.14E+03 | 1.82E+03 | 2.11E+04 | 7.20E+04 | 1.90E+04 |
| 0.6 | 1.65E+03 | 1.36E+03 | 1.14E+03 | 1.82E+03 | 4.09E+05 | 6.20E+05 | 3.57E+05 |
| 0.9 | 1.22E+03 | 1.27E+03 | 1.14E+03 | 1.82E+03 | 2.48E+06 | 2.96E+06 | 1.85E+06 |
| 1.9 | 1.78E+03 | 1.27E+03 | 1.14E+03 | 1.82E+03 | 5.58E+06 | 9.45E+06 | 6.37E+06 |
| 3.9 | 5.61E+04 | 1.80E+04 | 1.14E+03 | 1.82E+03 | 1.08E+07 | 1.27E+07 | 9.31E+06 |

**TABLE 21**

| **Time** (**sec**) | **Storage shear modulus (G'; Pa)** 50 mW/cm²/l sec exposure; 0.10 mm gap | | | | | |
|---|---|---|---|---|---|---|
| Seconds after light on | Example 31 | Example 32 | Example 33 | Example 34 | Example 35 | Example 36 |
| 0.4 | 1.52E+03 | 1.31E+03 | 1.17E+03 | 1.22E+03 | 1.15E+03 | 3.06E+03 |
| 0.6 | 9.97E+02 | 1.14E+03 | 1.26E+03 | 1.24E+03 | 1.07E+04 | 7.69E+04 |
| 0.9 | 1.21E+03 | 9.07E+02 | 4.95E+03 | 1.78E+03 | 9.93E+04 | 4.56E+05 |
| 1.9 | 1.75E+03 | 1.49E+03 | 7.42E+04 | 2.42E+04 | 2.77E+05 | 1.58E+06 |
| 3.9 | 3.82E+03 | 1.75E+03 | 1.09E+05 | 3.29E+04 | 4.59E+05 | 2.54E+06 |

**TABLE 22**

| **Time** (**sec**) | **Storage shear modulus (G'; Pa)** 44 mW/cm²/l sec exposure; 0.05 mm gap | | | | | | | |
|---|---|---|---|---|---|---|---|---|
| Seconds after light on | Example 37 | Example 38 | Example 39 | Example 40 | Example 41 | Example 42 | Example 43 | Example 44 |
| 0.4 | 8.67E+03 | 1.89E+05 | 7.71E+04 | 1.00E+05 | 4.46E+04 | 3.12E+05 | 8.28E+05 | 6.64E+05 |
| 0.6 | 1.12E+05 | 5.94E+05 | 4.52E+05 | 5.02E+05 | 2.50E+05 | 8.90E+05 | 1.11E+06 | 2.29E+06 |
| 0.9 | 4.62E+05 | 1.40E+06 | 1.46E+06 | 1.56E+06 | 9.16E+05 | 1.71E+06 | 1.97E+06 | 3.56E+06 |
| 1.9 | 1.10E+06 | 2.94E+06 | 2.73E+06 | 2.86E+06 | 1.64E+06 | 2.66E+06 | 3.30E+06 | 5.30E+06 |
| 3.9 | 1.63E+06 | 4.36E+06 | 4.56E+06 | 4.37E+06 | 2.66E+06 | 4.90E+06 | 4.86E+06 | 5.15E+06 |

**TABLE 23**

| **Time** (**sec**) | **Storage shear modulus (G'; Pa)** 44 mW/cm²/l sec exposure; 0.10 mm gap | | | | | | | |
|---|---|---|---|---|---|---|---|---|
| Seconds after light on | Example 37 | Example 38 | Example 39 | Example 40 | Example 41 | Example 42 | Example 43 | Example 44 |
| 0.4 | 1.14E+03 | 5.17E+03 | 1.14E+03 | 6.31E+03 | 9.45E+02 | 2.57E+04 | 6.07E+03 | 2.75E+04 |
| 0.6 | 1.16E+03 | 2.77E+04 | 1.16E+03 | 2.32E+04 | 2.85E+03 | 1.25E+05 | 5.31E+04 | 3.05E+05 |
| 0.9 | 1.82E+04 | 2.22E+05 | 1.82E+04 | 2.44E+05 | 6.57E+04 | 6.39E+05 | 5.11E+05 | 1.19E+06 |
| 1.9 | 1.87E+05 | 8.47E+05 | 1.87E+05 | 1.12E+06 | 3.89E+05 | 2.20E+06 | 2.11E+06 | 3.17E+06 |
| 3.9 | 2.74E+05 | 1.26E+06 | 2.76E+05 | 1.79E+06 | 6.83E+05 | 3.19E+06 | 3.00E+06 | 4.21E+06 |

**TABLE 24**

| Tensile test on thin cured strips (24 h after cure) | | | | | | | |
|---|---|---|---|---|---|---|---|
| | Example 6 | Example 7 | Example 8 | Example 9 | Example 10 | Example 11 | Example 12 |
| Elastic Modulus (MPa) | 1403 | 1023 | 666 | 537 | 1030 | 2262 | 1892 |
| Elongation at Break (%) | 5.8 | 10.9 | 19.5 | 14.6 | 7.9 | 2.9 | 2.2 |
| Tensile Strength (MPa) | 44.2 | 32.4 | 26.5 | 17.8 | 35.7 | 51.9 | 35.8 |

**TABLE 25**

| Tensile test on thin cured strips (24 h after cure) | | | |
|---|---|---|---|
| | Example 28 | Example 29 | Example 30 |
| Elastic Modulus (MPa) | 1674 | 1968 | 1590 |
| Elongation at Break (%) | 4.9 | 3.3 | 2.1 |
| Tensile Strength (MPa) | 50.6 | 49.9 | 29.6 |

**TABLE 26**

| Tensile test on thin cured strips (24 hrs after cure) | | | | | | | | |
|---|---|---|---|---|---|---|---|---|
| | Example 37 | Example 38 | Example 39 | Example 40 | Example 41 | Example 42 | Example 43 | Example 44 |
| Elastic Modulus (MPa) | 1811 | 1685 | 1844 | 1692 | 1769 | 1681 | 1786 | 394 |
| Elongation at Break (%) | 2.5 | 1.5 | 1.9 | 1.1 | 2.5 | 1.6 | 0.9 | 14.4 |
| Tensile Strength (MPa) | 39.1 | 22.1 | 28.7 | 18.1 | 38.4 | 24.5 | 14.2 | 19.0 |

**TABLE 27**

| **Example No**. | **CPI/RPI** | **CPC**/**RPC** |
|---|---|---|
| 1 | 1.33 | 1.13 |
| 2 | 0.18 | 3.19 |
| 3 | 0.25 | 3.19 |
| 4 | 0.43 | 3.19 |
| 5 | 0.67 | 3.19 |
| 6 | 0.67 | 1.37 |
| 7 | 0.67 | 1.30 |
| 8 | 0.67 | 1.23 |
| 9 | 0.67 | 1.33 |
| 10 | 0.67 | 1.33 |
| 11 | 0.67 | 1.47 |
| 12 | 0.67 | 1.55 |
| 13 | 0.67 | 1.47 |
| 14 | 0.67 | 1.47 |
| 15 | 0.25 | 1.48 |
| 16 | 0.25 | 1.48 |
| 17 | 0.25 | 1.48 |
| 18 | 0.25 | 1.48 |
| 19 | 0.25 | 2.23 |
| 20 | 0.25 | 2.27 |
| 21 | 0.25 | 2.23 |
| 22 | 0.25 | 0.94 |
| 23 | 0.25 | N/A |
| 24 | 0.25 | N/A |
| 25 | 0.25 | N/A |
| 26 | 0.25 | N/A |
| 27 | 0.25 | N/A |
| 28 | 0.25 | 0.54 |
| 29 | 0.25 | 0.54 |
| 30 | 0.25 | 0.54 |
| 31 | 0.82 | 3.56 |
| 32 | 0.76 | 1.10 |
| 33 | 0.76 | 1.10 |
| 34 | 0.82 | 3.56 |
| 35 | 1.22 | 3.56 |
| 36 | 1.26 | 1.10 |
| 37 | 0.50 | 1.87 |
| 38 | 0.50 | 1.87 |
| 39 | 0.50 | 1.87 |
| 40 | 0.50 | 1.87 |
| 41 | 0.50 | 1.87 |
| 42 | 0.50 | 1.87 |
| 43 | 0.50 | 1.87 |
| 44 | 0.50 | 1.87 |
| 45 | 0.71 | 6.50 |
| 46 | 0.71 | 6.50 |
| 47 | 0.88 | 6.53 |
| 48 | 4.09 | 6.53 |
| 49 | 1.02 | 6.53 |
| 50 | 0.70 | 6.53 |
| 51 | 0.35 | 6.53 |
| 52 | 1.29 | 6.53 |
| 53 | 1.29 | 6.53 |
| 54 | 1.29 | 6.53 |
| 55 | 1.29 | 6.53 |
| 56 | 0.40 | 6.56 |

### COMPARATIVE EXAMPLE 1

This comparative example illustrates the results obtained when curing a typical laser curable resin with LED light. A solid state laser emitting at 354.7 nm is used, with 1 mil scan spacing, 65 mW/cm² power, and 58 kHz frequency, for obtaining the Ec and Dp values from the "working curve"by using WINDOWPANES™ technique. The LED is a single UV LED "bare bulb" (Model No. NCSU033A; Nichia Corporation, Japan) having a peak wavelength of 365 nm and is used as the LED light source in a light curing apparatus, wherein the single LED light is bottom-mounted on a flat surface inside a 30 °C chamber and positioned in an upward-looking arrangement and pointing vertically. The LED light is powered by a 3.30 V / 0.050 A DC output from a Programmable Power Supply (Model No. PSS-3203; GW Instek).

The composition of Comparative Example 1 is shown in Table 28. Ec and Dp data, as determined using the previously mentioned methods, when cured with both laser light and LED light is shown in Table 29.

**TABLE 28**

| Comparative Example 1 | |
|---|---|
| Component | wt% |
| Ebecryl 3700 | 20 |
| Celloxy 2021P | 70.78 |
| Chivacure 1176 | 5 |
| Irgacure 184 | 4 |
| Silwet 7600 | 0.2 |
| BYK A501 | 0.02 |
| | |
| Total | 100 |

**TABLE 29**

| | Laser Light | LED Light |
|---|---|---|
| Ec | 6.89 mJ/cm² | 0.45 seconds |
| Dp | 4.10 mils | 19.05 mils |

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention defined by the appended claims unless otherwise indicated herein or otherwise clearly contradicted by context.

## Claims

1. A photocurable resin composition for additive fabrication comprising a polymerizable component that is polymerizable by free-radical polymerization, cationic polymerization, or both free-radical polymerization and cationic polymerization, and a photoinitiating system capable of initiating the free-radical polymerization, cationic polymerization, or both free-radical polymerization and cationic polymerization,;
wherein the photocurable resin composition is a liquid at 25 °C, and is capable of curing to provide a solid upon irradiation with light emitted from a light emitting diode (LED), wherein the light has a wavelength of from 100 nm to 900 nm, and
wherein the liquid photocurable resin composition has a Critical Exposure (Ec) and a Depth of Penetration (Dp) as measured on a layer of the photocurable resin composition as the composition is curing and calculated as described herein, wherein Ec is from 0.01 seconds to 6.0 seconds and Dp is from 0.03 mm to 0.2 mm (1 to 8 mils).

2. The photocurable resin composition for additive fabrication of claim 1, where the photocurable resin composition is capable of curing to provide a solid upon irradiation with light emitted from a light emitting diode (LED), wherein the light has a wavelength of from 340 nm to 415 nm.

3. The photocurable resin composition for additive fabrication of claim 1 or 2, wherein the Dp is 0.03 mm to 0.1 mm (1 to 7 mils).

4. The photocurable resin composition for additive fabrication of any one of claims 1-3, wherein the photocurable resin composition as it is curing with a light intensity of 50 mW/cm² for 1.0 second has a storage shear modulus (G') value of greater than 1.0 × 10⁵ Pa when it is measured at 3.9 seconds from the start of light exposure on a Real Time-Dynamic Mechanical Analyzer (RT-DMA) with an 8 mm plate at a sample gap of 0.10 mm and calculated as described herein.

5. The photocurable resin composition for additive fabrication of any one of claims 1-4, wherein the photocurable resin composition for additive fabrication comprises at least one free-radical photoinitiator.

6. The photocurable resin composition for additive fabrication of any one of claims 1-5, wherein the photoinitiating system is a photoinitiator having both cationic initiating function and free radical initiating function.

7. The photocurable resin composition for additive fabrication of any one of claims 1-6, wherein the photocurable resin composition for additive fabrication comprises at least one cationic photoinitiator.

8. The photocurable resin composition for additive fabrication of any one of claims 1-7, comprising at least one cationic photoinitiator, wherein
(a) the cationic photoinitiator is an aromatic sulfonium salt based cationic photoinitiator selected from the group consisting of 4-(4-benzoylphenylthio)phenyldiphenylsulfonium hexafluoroantimonate, 4-(4-benzoylphenylthio)phenylbis(4-hydroxyethyloxyphenyl)sulfonium hexafluoroantimonate, 4-(4-benzoylphenylthio)phenylbis(4-fluorophenyl)sulfonium hexafluoroantimonate, 4-(4-benzoylphenylthio)phenylbis(4-chlorophenyl)sulfonium hexafluoroantimonate, 4-[4-(3-chlorobenzoyl)phenylthio]phenylbis(4-fluorophenyl)sulfonium hexafluoroantimonate, 4-(4-benzoylphenylthio)phenylbis(4-methylpheny])sulfonium hexafluoroantimonate, 4-(4-benzoylphenylthio)phenylbis(4-hydroxyethylphenyl)sulfonium hexafluoroantimonate, 4-[4-(4-hydroxyethyloxybenzoyl)phenylthio]phenylbis(4-fluoro phenyl)sulfonium hexafluoroantimonate, 4-[4-(4-hydroxyethyloxybenzoyl)phenylthio]phenyldiphenylsulfonium hexafluoroantimonate, 4-[4-(4-hydroxyethyloxybenzoyl)phenylthio]phenylbis(4-hydroxyethyloxy phenyl)sulfonium hexafluoroantimonate, 4-(4-benzoylphenylthio)phenylbis(4-methoxyethoxyphenyl)sulfonium hexafluoroantimonate, 4-[4-(3-methoxybenzoyl)phenylthio]phenyldiphenylsulfonium hexafluoroantimonate, 4-[4-(3-methoxycarbonylbenzoyl)phenylthio]phenyldiphenylsulfonium hexafluoroantimonate, 4-[4-(2-hydroxymethylbenzoyl)phenylthio]phenyldiphenylsulfonium hexafluoroantimonate, 4-[4-(4-methylbenzoyl)phenylthio]phenylbis(4-fluorophenyl)sulfonium hexafluoroantimonate, 4-[4-(4-)phenylthio]phenylbis(4-fluorophenyl)sulfonium hexafluoroantimonate, 4-[4-(4-fluorobenzoyl)phenylthio]phenylbis(4-fluorophenyl)sulfonium hexafluoroantimonate, 4-[4-(2-methoxycarbonylbenzoyl)phenylthio]phenylbis(4-fluorophenyl) sulfonium hexafluoroantimonate, bis[4-(diphenylsulfonio)phenyl]sulfide bishexafluorophosphate, bis[4-(diphenylsulfonio)phenyl]sulfide bistetrafluoroborate, bis[4-(diphenylsulfonio)phenyl]sulfide tetrakis(pentafluorophenyl)borate, diphenyl-4-(phenylthio)phenylsulfonium hexafluorophosphate, diphenyl-4-(phenylthio)phenylsulfonium tetrafluoroborate, diphenyl-4-(phenylthio)phenylsulfonium tetrakis(pentafluorophenyl)borate, triphenylsulfonium hexafluorophosphate, triphenylsulfonium hexafluoroantimonate, triphenylsulfonium tetrafluoroborate, triphenylsulfonium tetrakis(pentafluorophenyl)borate, bis[4-(di(4-(2-hydroxyethoxy))phenylsulfonio)phenyl] sulfide bishexafluorophosphate, bis[4-(di(4-(2-hydroxyethoxy))phenylsulfonio)phenyl] sulfide bistetrafluoroborate, and bis [4-(di(4-(2-hydroxyethoxy))phenylsulfonio)phenyl] sulfide tetrakis(pentafluorophenyl)borate;
and/or
(b) wherein the cationic photoinitiator is an aromatic iodonium salt based cationic photoinitiator selected from the group consisting of diphenyliodonium hexafluorophosphate, diphenyliodonium hexafluoroantimonate, diphenyliodonium tetrafluoroborate, diphenyliodonium tetrakis(pentafluorophenyl)borate, bis(dodecylphenyl)iodonium hexafluorophosphate, bis(dodecylphenyl)iodonium hexafluoroantimonate, bis(dodecylphenyl)iodonium tetrafluoroborate, bis(dodecylphenyl)iodonium tetrakis(pentafluorophenyl)borate, 4-methylphenyl-4-(1-methylethyl)phenyliodonium hexafluorophosphate, 4-methylphenyl-4-(1-methylethyl)pheny]iodonium hexafluoroantimonate, 4-methylphenyl-4-(1-methylethyl)phenyliodonium tetrafluoroborate, and 4-methylphenyl-4-(1-methylethyl)phenyliodonium tetrakis(pentafluorophenyl)borate;
and/or
(c) wherein the cationic photoinitiator is one or more selected from the group consisting of tetrakis(pentafluorophenyl)borate or hexafluoroantimonate salt of 4-(4-benzoylphenylthio)phenyldiphenylsulfonium, 4-(4-benzoylphenylthio)phenylbis(4-hydroxyethyloxyphenyl)sulfonium, 4-(4-benzoylphenylthio)phenylbis(4-fluorophenyl)sulfonium, 4-(4-benzoylphenylthio)phenylbis(4-chlorophenyl)sulfonium, 4-[4-(3-chlorobenzoyl)phenylthio]phenylbis(4-fluorophenyl)sulfonium, 4-[4-(2-chlorobenzoyl)phenylthio]phenylbis(4-fluorophenyl)sulfonium, (4-thiophenoxyphenyl)diphenylsulfonium, S,S,S',S'-tetraphenylthiobis(4,1-phenylene)disulfonium, triphenylsulfonium, (chlorophenyl)diphenylsulfonium, chloro[S-(phenyl)thianthrenium], S-(phenyl)thianthrenium, diphenyl-4-(4'-thiophenoxy)thiophenoxyphenylsulfonium, phenyldi(4-thiophenoxyphenyl)sulfonium, S-(4-thiophenoxyphenyl)thianthrenium, and (thiodi-4,1-phenylene)bis[bis[4-(2-hydroxyethoxy)phenyl]sulfonium, tris(4-(4-acetylphenyl)thiophenyl)sulfonium, bis(4-dodecylphenyl)iodonium, [4-[(2-hydroxytetradecyl)oxy]phenyl]phenyliodonium, (4-methylphenyl) [4-[[2-[[[[3-(trifluoromethyl)phenyl]amino]carbonyl]oxy] tetradecyl]oxy]phenyl]iodonium, bis(4-dodecylphenyl)iodonium, [4-(1-methylethyl)phenyl](4-methylphenyl)iodonium;
and/or
(d) wherein the cationic photoiniator is a sulfonium borate photoinitiator.

9. The photocurable resin composition for additive fabrication of any one of claims 1-8, wherein the polymerizable component is polymerizable by both free-radical polymerization and cationic polymerization.

10. The photocurable resin composition for additive fabrication of any one of claims 1-9, which further includes
(a) a chain transfer agent; and/or
(b) one or more additives selected from the group consisting of bubble breakers, antioxidants, surfactants, acid scavengers, pigments, dyes, thickeners, flame retardants, silane coupling agents, ultraviolet absorbers, resin particles, core-shell particle impact modifiers, soluble polymers and block polymers.

11. The photocurable resin composition for additive fabrication of any one of claims 1-10, comprising at least one cationic photoinitiator and at least one free-radical photoinitiator wherein the ratio by weight of cationic photoinitiator to free-radical photoinitiator is less than 4.0.

12. The photocurable resin composition for additive fabrication of any one of claims 1-11, which further includes a photosensitizer, preferably selected from the group consisting of methanones, xanthenones, pyrenemethanols, anthracenes, quinones, xanthones, thioxanthones, benzoyl esters, benzophenones, and any combination thereof, more preferably selected from the group consisting of [4-[(4-methylphenyl)thio]phenyl]phenyl-methanone, isopropyl-9*H*-thioxanthen-9-one, 1-pyrenemethanol, 9-(hydroxymethyl)anthracene, 9,10-diethoxyanthracene, anthracene, anthraquinones, 2-methylanthraquinone, 2-ethylanthraquinone, 2-*tert*-butylanthraquinone, 1-chloroanthraquinone, 2-amylanthraquinone, thioxanthones and xanthones, isopropyl thioxanthone, 2-chlorothioxanthone, 2,4-diethylthioxanthone, 1-chloro-4-propoxythioxanthone, methyl benzoyl formate, methyl-2-benzoyl benzoate, 4-benzoyl-4'-methyl diphenyl sulphide, 4,4'-*bis*(diethylamino)benzophenone, and any combination thereof.

13. The photocurable resin composition for additive fabrication of any one of claims 1-12, wherein the photocurable resin composition is free of antimony-containing initiator or has less than 1.5 % by weight of antimony-containing initiator.

14. The photocurable resin composition for additive fabrication of any one of claims 1-13, comprising at least one cationic polymerizable component and at least one free-radical polymerizable component, wherein the ratio by weight of cationic polymerizable component to free-radical polymerizable component is less than 7.0.

15. A process for making a three-dimensional object comprising the steps of forming and selectively curing a layer of the photocurable resin composition for additive fabrication of any one of claims 1-14 by irradiation with light from a light emitting diode (LED) having a wavelength from 100 nm to 900 nm, preferably from 340 nm to 415 nm, and repeating the steps of forming and selectively curing a layer of the photocurable resin composition a plurality of times to obtain a three-dimensional object.

## Patentansprüche

1. Photohärtbare Harzzusammensetzung zur Additivherstellung, umfassend eine polymerisierbare Komponente, die durch radikalische Polymerisation, kationische Polymerisation oder sowohl radikalische Polymerisation als auch kationische Polymerisation polymerisierbar ist, und ein Photoinitiierungssystem, das die radikalische Polymerisation, die kationische Polymerisation oder sowohl die radikalische Polymerisation als auch die kationische Polymerisation initiieren kann;
wobei die photohärtbare Harzzusammensetzung bei 25°C flüssig ist und bei Bestrahlung mit Licht aus einer Leuchtdiode (LED), wobei das Licht eine Wellenlänge von 100 nm bis 900 nm aufweist, zu einem Feststoff gehärtet werden kann und
wobei die flüssige photohärtbare Harzzusammensetzung eine kritische Exposition (Critical Exposure, Ec) und eine Eindringtiefe (Depth of Penetration, Dp), wie an einer Schicht der photohärtbaren Harzzusammensetzung bei der Härtung der Zusammensetzung gemessen und wie hier beschrieben berechnet, aufweist, wobei Ec 0,01 Sekunden bis 6,0 Sekunden beträgt und Dp 0,03 mm bis 0,2 mm (1 bis 8 Millizoll) beträgt.

2. Photohärtbare Harzzusammensetzung zur Additivherstellung nach Anspruch 1, wobei die photohärtbare Harzzusammensetzung bei Bestrahlung mit Licht aus einer Leuchtdiode (LED), wobei das Licht eine Wellenlänge von 340 nm bis 415 nm aufweist, zu einem Feststoff gehärtet werden kann.

3. Photohärtbare Harzzusammensetzung zur Additivherstellung nach Anspruch 1 oder 2, wobei die Dp 0,03 mm bis 0,1 mm (1 bis 7 Millizoll) beträgt.

4. Photohärtbare Harzzusammensetzung zur Additivherstellung nach einem der Ansprüche 1-3, wobei die photohärtbare Harzzusammensetzung bei der Härtung mit einer Lichtintensität von 50 Mw/cm² über einen Zeitraum von 1,0 Sekunden einen Wert für den Speicherschubmodul (G') von mehr als 1,0·10⁵ Pa bei Messung an einem Zeitpunkt von 3,9 Sekunden ab dem Beginn der Lichtexposition auf einem Gerät zur dynamisch-mechanischen Echtzeit-Analyse (Real Time-Dynamic Mechanical Analyzer, RT-DMA) mit einer 8-mm-Platte bei einem Probenspalt von 0,10 mm und wie hier beschrieben berechnet aufweist.

5. Photohärtbare Harzzusammensetzung zur Additivherstellung nach einem der Ansprüche 1-4, wobei die photohärtbare Harzzusammensetzung zur Additivherstellung mindestens einen radikalischen Photoinitiator umfasst.

6. Photohärtbare Harzzusammensetzung zur Additivherstellung nach einem der Ansprüche 1-5, wobei es sich bei dem Photoinitiierungssystem um einen Photoinitiator, der sowohl kationische initiierende Funktion als auch radikalische initiierende Funktion aufweist.

7. Photohärtbare Harzzusammensetzung zur Additivherstellung nach einem der Ansprüche 1-6, wobei die photohärtbare Harzzusammensetzung zur Additivherstellung mindestens einen kationischen Photoinitiator umfasst.

8. Photohärtbare Harzzusammensetzung zur Additivherstellung nach einem der Ansprüche 1-7, die mindestens einen kationischen Photoinitiator umfasst, wobei
(a) es sich bei dem kationischen Photoinitiator um einen auf aromatischem Sulfoniumsalz basierenden kationischen Photoinitiator aus der Gruppe bestehend aus 4-(4-Benzoylphenylthio)phenyldiphenylsulfoniumhexafluoroantimonat, 4-(4-Benzoylphenylthio)phenylbis(4-hydroxy-ethyloxyphenyl)sulfoniumhexafluoroantimonat, 4-(4-Benzoylphenylthio)phenylbis(4-fluorphenyl)sulfoniumhexafluoroantimonat, 4-(4-Benzoylphenylthio)phenylbis(4-chlorphenyl)sulfoniumhexafluoroantimonat, 4-[4-(3-Chlorbenzoyl)phenylthio]phenylbis(4-fluorphenyl)sulfoniumhexafluoroantimonat, 4-(4-Benzoylphenylthio)phenylbis(4-methylphenyl)sulfoniumhexafluoroantimonat, 4-(4-Benzoylphenylthio)phenylbis(4-hydroxy-ethylphenyl)sulfoniumhexafluoroantimonat, 4-[4-(4-Hydroxyethyloxybenzoyl)phenylthio]-phenylbis(4-fluorphenyl)sulfoniumhexafluoro-antimonat, 4-[4-(4-Hydroxyethyloxybenzoyl)phenylthio]-phenyldiphenylsulfoniumhexafluoroantimonat, 4-[4-(4-Hydroxyethyloxybenzoyl)phenylthio]-phenylbis(4-hydroxyethyloxyphenyl)sulfonium-hexafluoroantimonat, 4-(4-Benzoylphenylthio)phenylbis(4-methoxyethoxyphenyl)sulfoniumhexafluoroantimonat, 4-[4-(3-Methoxybenzoyl)phenylthio]phenyl-diphenylsulfoniumhexafluoroantimonat, 4-[4-(3-Methoxycarbonylbenzoyl)phenylthio]-phenyldiphenylsulfoniumhexafluoroantimonat, 4-[4-(2-Hydroxymethylbenzoyl)phenylthio]-phenyldiphenylsulfoniumhexafluoroantimonat, 4-[4-(4-Methylbenzoyl)phenylthio]phenylbis(4-fluorphenyl)sulfoniumhexafluoroantimonat, 4-[4-(4-)Phenylthio]phenylbis(4-fluorphenyl)-sulfoniumhexafluoroantimonat, 4-[4-(4-Fluorbenzoyl)phenylthio]phenylbis(4-fluorphenyl)sulfoniumhexafluoroantimonat, 4-[4-(2-Methoxycarbonylbenzoyl)phenylthio]-phenylbis(4-fluorphenyl)sulfoniumhexafluoro-antimonat, Bis[4-(diphenylsulfonio)phenyl]sulfidbishexa-fluorophosphat, Bis[4-(diphenylsulfonio)phenyl]sulfid-bistetrafluoroborat, Bis[4-(diphenylsulfonio)phenyl]sulfid-tetrakis(pentafluorphenyl)borat, Diphenyl-4-(phenylthio)phenylsulfoniumhexa-fluorophosphat, Diphenyl-4-(phenylthio)phenylsulfoniumtetra-fluoroborat, Diphenyl-4-(phenylthio)phenylsulfonium-tetrakis(pentafluorphenyl)borat, Triphenylsulfoniumhexafluorophosphat, Triphenylsulfoniumhexafluoroantimonat, Triphenylsulfoniumtetrafluoroborat, Triphenylsulfoniumtetrakis(pentafluorphenyl)-borat, Bis[4-(di(4-(2-hydroxyethoxy))phenyl-sulfonio)phenyl]sulfidbishexafluorophosphat, Bis[4-(di(4-(2-hydroxyethoxy))phenyl-sulfonio)phenyl]sulfidbistetrafluoroborat und Bis[4-(di(4-(2-hydroxyethoxy))phenyl-sulfonio)phenyl]sulfidtetrakis(pentafluorphenyl)borat handelt
und/oder
(b) wobei es sich bei dem kationischen Photoinitiator um einen auf aromatischem Iodoniumsalz basierenden kationischen Photoinitiator aus der Gruppe bestehend aus Diphenyliodoniumhexafluorophosphat, Diphenyliodoniumhexafluoroantimonat, Diphenyliodoniumtetrafluoroborat, Diphenyliodoniumtetrakis(pentafluorphenyl)-borat, Bis(dodecylphenyl)iodoniumhexafluorophosphat, Bis(dodecylphenyl)iodoniumhexafluoro-antimonat, Bis(dodecylphenyl)iodoniumtetrafluoroborat, Bis(dodecylphenyl)iodoniumtetrakis(pentafluorphenyl)borat, 4-Methylphenyl-4-(1-methylethyl)phenyl-iodoniumhexafluorophosphat, 4-Methylphenyl-4-(1-methylethyl)phenyl-iodoniumhexafluoroantimonat, 4-Methylphenyl-4-(1-methylethyl)phenyl-iodoniumtetrafluoroborat und 4-Methylphenyl-4-(1-methylethyl)phenyl-iodoniumtetrakis(pentafluorphenyl)borat handelt
und/oder
(c) wobei es sich bei dem kationischen Photoinitiator um einen oder mehrere aus der Gruppe bestehend aus Tetrakis(pentafluorphenyl)borat oder Hexa-fluoroantimonatsalz von 4-(4-Benzoylphenyl-thio)phenyldiphenylsulfonium, 4-(4-Benzoyl-phenylthio)phenylbis(4-hydroxyethyloxy-phenyl)sulfonium, 4-(4-Benzoylphenylthio)-phenylbis(4-fluorphenyl)sulfonium, 4-(4-Benzoylphenylthio)phenylbis(4-chlorphenyl)-sulfonium, 4-[4-(3-Chlorbenzoyl)phenylthio]-phenylbis(4-fluorphenyl)sulfonium, 4-[4-(2-Chlorbenzoyl)phenylthio]phenylbis(4-fluor-phenyl)sulfonium, (4-Thiophenoxyphenyl)-diphenylsulfonium, S,S,S',S'-Tetraphenylthio-bis(4,1-phenylen)disulfonium, Triphenylsulfonium, (Chlorphenyl)diphenylsulfonium, Chlor[S-(phenyl)thianthrenium], S-(Phenyl)-thianthrenium, Diphenyl-4-(4'-thiophenoxy)-thiophenoxyphenylsulfonium, Phenyldi(4-thio-phenoxyphenyl)sulfonium, S-(4-Thiophenoxy-phenyl)thianthrenium und (Thiodi-4,1-phenylen)bis[bis[4-(2-hydroxyethoxy)phenyl]-sulfonium, Tris(4-(4-acetylphenyl)thio-phenyl)sulfonium, Bis(4-dodecylphenyl)-iodonium, [4-[(2-Hydroxytetradecyl)oxy]-phenyl]phenyliodonium, (4-Methylphenyl)[4-[[2-[[[[3-(trifluormethyl)phenyl]amino]-carbonyl]oxy]tetradecyl]oxy]phenyl]iodonium, Bis(4-dodecylphenyl)iodonium, [4-(1-Methyl-ethyl)phenyl](4-methylphenyl)iodonium und einer beliebigen Kombination davon handelt
und/oder
(d) wobei es sich bei dem kationischen Photoinitiator um einen Sulfoniumborat-Photoinitiator handelt.

9. Photohärtbare Harzzusammensetzung zur Additivherstellung nach einem der Ansprüche 1-8, wobei die polymerisierbare Komponente sowohl durch radikalische Polymerisation als auch durch kationische Polymerisation polymerisierbar ist.

10. Photohärtbare Harzzusammensetzung zur Additivherstellung nach einem der Ansprüche 1-9, die ferner Folgendes enthält:
(a) ein Kettenübertragungsmittel und/oder
(b) ein oder mehrere Additive aus der Gruppe bestehend aus Blasenbrechern, Antioxidantien, Tensiden, Säurefängern, Pigmenten, Farbstoffen, Verdickern, Flammschutzmitteln, Silan-Kupplungsmitteln, Ultraviolettabsorbern, Harzteilchen, Kern-Schale-Teilchen-Schlagzähigkeitsmodifikatoren, löslichen Polymeren und Blockcopolymeren.

11. Photohärtbare Harzzusammensetzung zur Additivherstellung nach einem der Ansprüche 1-10, die mindestens einen kationischen Photoinitiator und mindestens einen radikalischen Photoinitiator umfasst, wobei das Gewichtsverhältnis von kationischem Photoinitiator zu radikalischem Photoinitiator weniger als 4,0 beträgt.

12. Photohärtbare Harzzusammensetzung zur Additivherstellung nach einem der Ansprüche 1-11, die ferner einen Photosensibilisator enthält, der vorzugsweise aus der Gruppe bestehend aus Methanonen, Xanthenonen, Pyrenmethanolen, Anthracenen, Chinonen, Xanthonen, Thioxanthonen, Benzoylestern, Benzophenonen und einer beliebigen Kombination davon und weiter bevorzugt aus der Gruppe bestehend aus [4-[(4- Methylphenyl)thio]-phenyl]phenylmethanon, Isopropyl-9H-thioxanthen-9-on, 1-Pyrenmethanol, 9-(Hydroxymethyl)anthracen, 9,10-Diethoxyanthracen, Anthracen, Anthrachinonen, 2-Methylanthrachinon, 2-Ethylanthrachinon, 2-tert-Butylanthrachinon, 1-Chloranthrachinon, 2-Amylanthrachinon, Thioxanthonen und Xanthonen, Isopropylthioxanthon, 2-Chlorthioxanthon, 2,4-Diethylthioxanthon, 1-Chlor-4-propoxythioxanthon, Benzoylameisensäuremethylester, 2-Benzoylbenzoesäuremethylester, 4-Benzoyl-4'-methyldiphenyl-sulfid, 4,4'-Bis(diethylamino)benzophenon und einer beliebigen Kombination davon ausgewählt ist.

13. Photohärtbare Harzzusammensetzung zur Additivherstellung nach einem der Ansprüche 1-12, wobei die photohärtbare Harzzusammensetzung frei von antimonhaltigem Initiator ist oder weniger als 1,5 Gew.-% antimonhaltigen Initiator aufweist.

14. Photohärtbare Harzzusammensetzung zur Additivherstellung nach einem der Ansprüche 1-13, die mindestens eine kationische polymerisierbare Komponente und mindestens eine radikalisch polymerisierbare Komponente umfasst, wobei das Gewichtsverhältnis von kationisch polymerisierbarer Komponente zu radikalisch polymerisierbarer Komponente weniger als 7,0 beträgt.

15. Verfahren zur Herstellung eines dreidimensionalen Objekts, umfassend die Schritte des Bildens und selektiven Härtens einer Schicht der photohärtbaren Harzzusammensetzung zur Additivherstellung nach einem der Ansprüche 1-14 durch Bestrahlung mit Licht aus einer Leuchtdiode (LED) mit einer Wellenlänge von 100 nm bis 900 nm, vorzugsweise von 340 nm bis 415 nm, und mehrmaliges Wiederholen der Schritte des Bildens und selektiven Härtens einer Schicht aus der photohärtbaren Harzzusammensetzung zum Erhalt eines dreidimensionalen Objekts.

## Revendications

1. Composition de résine photodurcissable pour fabrication additive comprenant un constituant polymérisable qui est polymérisable par polymérisation radicalaire, polymérisation cationique, ou à la fois polymérisation radicalaire et polymérisation cationique, et un système photoinitiateur susceptible d'initier la polymérisation radicalaire, la polymérisation cationique, ou à la fois la polymérisation radicalaire et la polymérisation cationique ;
la composition de résine photodurcissable étant un liquide à 25 °C, et étant susceptible de durcir pour donner un solide sous irradiation avec une lumière émise depuis une diode électroluminescente (DEL), la lumière ayant une longueur d'onde de 100 nm à 900 nm, et
la composition de résine photodurcissable liquide ayant une exposition critique (Ec) et une profondeur de pénétration (Dp) telles que mesurées sur une couche de la composition de résine photodurcissable lorsque la composition durcit et calculées comme décrit dans les présentes, Ec étant de 0,01 seconde à 6,0 secondes et Dp étant de 0,03 mm à 0,2 mm (1 à 8 mils).

2. Composition de résine photodurcissable pour fabrication additive de la revendication 1, la composition de résine photodurcissable étant susceptible de durcir pour donner un solide sous irradiation avec une lumière émise depuis une diode électroluminescente (DEL), la lumière ayant une longueur d'onde de 340 nm à 415 nm.

3. Composition de résine photodurcissable pour fabrication additive de la revendication 1 ou 2, la Dp étant de 0,03 mm à 0,1 mm (1 à 7 mils).

4. Composition de résine photodurcissable pour fabrication additive de l'une quelconque des revendications 1 à 3, la composition de résine photodurcissable, lorsqu'elle durcit avec une intensité lumineuse de 50 mW/cm² pendant 1,0 seconde, ayant une valeur de module de conservation en cisaillement (G') supérieure à 1,0x10⁵ Pa lorsqu'elle est mesurée à 3,9 secondes du début de l'exposition lumineuse sur un analyseur mécanique dynamique en temps réel (RT-DMA) avec une plaque de 8 mm à un interstice pour l'échantillon de 0,10 mm et calculée comme décrit dans les présentes.

5. Composition de résine photodurcissable pour fabrication additive de l'une quelconque des revendications 1 à 4, la composition de résine photodurcissable pour fabrication additive comprenant au moins un photoinitiateur radicalaire.

6. Composition de résine photodurcissable pour fabrication additive de l'une quelconque des revendications 1 à 5, le système photoinitiateur étant un photoinitiateur ayant à la fois une fonction d'initiation cationique et une fonction d'initiation radicalaire.

7. Composition de résine photodurcissable pour fabrication additive de l'une quelconque des revendications 1 à 6, la composition de résine photodurcissable pour fabrication additive comprenant au moins un photoinitiateur cationique.

8. Composition de résine photodurcissable pour fabrication additive de l'une quelconque des revendications 1 à 7, comprenant au moins un photoinitiateur cationique, dans laquelle
(a) le photoinitiateur cationique est un photoinitiateur cationique à base de sel de sulfonium aromatique choisi dans le groupe constitué par l'hexafluoroantimonate de 4-(4-benzoylphénylthio)-phényldiphénylsulfonium, l'hexafluoroantimonate de 4-(4-benzoylphénylthio)-phénylbis(4-hydroxyéthyloxyphényl)sulfonium, l'hexafluoroantimonate de 4-(4-benzoylphénylthio)-phénylbis(4-fluorophényl)sulfonium, l'hexafluoroantimonate de 4-(4-benzoylphénylthio)-phénylbis(4-chlorophényl)sulfonium, l'hexafluoroantimonate de 4-[4-(3-chlorobenzoyl)-phénylthio]phénylbis(4-fluorophényl)sulfonium, l'hexafluoroantimonate de 4-(4-benzoylphénylthio)-phénylbis(4-méthylphényl)sulfonium, l'hexafluoroantimonate de 4-(4-benzoylphénylthio)-phénylbis(4-hydroxyéthylphényl)sulfonium, l'hexafluoroantimonate de 4-[4-(4-hydroxyéthyloxy-benzoyl)phénylthio]phénylbis(4-fluorophényl)sulfonium, l'hexafluoroantimonate de 4-[4-(4-hydroxyéthyloxy-benzoyl)phénylthio]phényldiphénylsulfonium, l'hexafluoroantimonate de 4-[4-(4-hydroxyéthyloxy-benzoyl)phénylthio]phénylbis(4-hydroxyéthyloxyphényl)-sulfonium, l'hexafluoroantimonate de 4-(4-benzoylphénylthio)-phénylbis(4-méthoxyéthoxyphényl)sulfonium, l'hexafluoroantimonate de 4-[4-(3-méthoxybenzoyl)-phénylthio]phényldiphénylsulfonium, l'hexafluoroantimonate de 4-[4-(3-méthoxycarbonyl-benzoyl)phénylthio]phényldiphénylsulfonium, l'hexafluoroantimonate de 4-[4-(2-hydroxyméthyl-benzoyl)phénylthio]phényldiphénylsulfonium, l'hexafluoroantimonate de 4-[4-(4-méthylbenzoyl)-phénylthio]phénylbis(4-fluorophényl)sulfonium, l'hexafluoroantimonate de 4-[4-(4-)phénylthio]-phénylbis(4-fluorophényl)sulfonium, l'hexafluoroantimonate de 4-[4-(4-fluorobenzoyl)-phénylthio]phénylbis(4-fluorophényl)sulfonium, l'hexafluoroantimonate de 4-[4-(2-méthoxycarbonyl-benzoyl)phénylthio]phénylbis(4-fluorophényl)sulfonium, le bishexafluorophosphate de sulfure de bis[4-(diphénylsulfonio)phényle], le bistétrafluoroborate de sulfure de bis[4-(diphénylsulfonio)phényle], le tétrakis(pentafluorophényl)borate de sulfure de bis[4-(diphénylsulfonio)phényle], l'hexafluorophosphate de diphényl-4-(phénylthio)-phénylsulfonium, le tétrafluoroborate de diphényl-4-(phénylthio)-phénylsulfonium, le tétrakis(pentafluorophényl)borate de diphényl-4-(phénylthio)phénylsulfonium, l'hexafluorophosphate de triphénylsulfonium, l'hexafluoroantimonate de triphénylsulfonium, le tétrafluoroborate de triphénylsulfonium, le tétrakis(pentafluorophényl)borate de triphénylsulfonium, le bishexafluorophosphate de sulfure de bis[4-(di(4-(2-hydroxyéthoxy))phénylsulfonio)phényle], le bistétrafluoroborate de sulfure de bis[4-(di(4-(2-hydroxyéthoxy))phénylsulfonio)phényle], et le tétrakis(pentafluorophényl)borate de sulfure de bis[4-(di(4-(2-hydroxyéthoxy))phénylsulfonio)phényle] ;
et/ou dans laquelle
(b) le photoinitiateur cationique est un photoinitiateur cationique à base de sel d'iodonium aromatique choisi dans le groupe constitué par l'hexafluorophosphate de diphényliodonium, l'hexafluoroantimonate de diphényliodonium, le tétrafluoroborate de diphényliodonium, le tétrakis(pentafluorophényl)borate de diphényliodonium, l'hexafluorophosphate de bis(dodécylphényl)iodonium, l'hexafluoroantimonate de bis(dodécylphényl)iodonium, le tétrafluoroborate de bis(dodécylphényl)iodonium, le tétrakis(pentafluorophényl)borate de bis(dodécylphényl)iodonium, l'hexafluorophosphate de 4-méthylphényl-4-(1-méthyléthyl)phényliodonium, l'hexafluoroantimonate de 4-méthylphényl-4-(1-méthyléthyl)phényliodonium, le tétrafluoroborate de 4-méthylphényl-4-(1-méthyléthyl)phényliodonium, et le tétrakis(pentafluorophényl)borate de 4-méthylphényl-4-(1-méthyléthyl)phényliodonium ;
et/ou dans laquelle
(c) le photoinitiateur cationique est un ou plusieurs éléments choisis dans le groupe constitué par le sel de tétrakis(pentafluorophényl)borate ou hexafluoroantimonate de 4-(4-benzoylphénylthio)phényldiphénylsulfonium, 4-(4-benzoylphénylthio)phénylbis(4-hydroxyéthyl-oxyphényl)sulfonium, 4-(4-benzoylphénylthio)phénylbis(4-fluorophényl)-sulfonium, 4-(4-benzoylphénylthio)phénylbis(4-chlorophényl)-sulfonium, 4-[4-(3-chlorobenzoyl)phénylthio]phénylbis(4-fluorophényl)sulfonium, 4-[4-(2-chlorobenzoyl)phénylthio]phénylbis(4-fluorophényl)sulfonium, (4-thiophénoxyphényl)diphénylsulfonium, S,S,S',S'-tétraphénylthiobis(4,1-phénylène)-disulfonium, triphénylsulfonium, (chlorophényl)diphénylsulfonium, chloro[S-(phényl)thianthrénium], S-(phényl)thianthrénium, diphényl-4-(4'-thiophénoxy)thiophénoxyphényl-sulfonium, phényldi(4-thiophénoxyphényl)sulfonium, S-(4-thiophénoxyphényl)thianthrénium, et (thiodi-4,1-phénylène)bis[bis[4-(2-hydroxyéthoxy)-phényl]sulfonium, tris(4-(4-acétylphényl)thiophényl)sulfonium, bis(4-dodécylphényl)iodonium, [4-[(2-hydroxytétradécyl)oxy]phényl]phényliodonium, (4-méthylphényl)[4-[[2-[[[[3-(trifluorométhyl)-phényl]amino]carbonyl]oxy]tétradécyl]oxy]phényl]iodoniu m, bis(4-dodécylphényl)iodonium, [4-(1-méthyléthyl)phényl](4-méthylphényl)iodonium ; et/ou dans laquelle
(d) le photoinitiateur cationique est un photoinitiateur à base de borate de sulfonium.

9. Composition de résine photodurcissable pour fabrication additive de l'une quelconque des revendications 1 à 8, le constituant polymérisable étant polymérisable à la fois par polymérisation radicalaire et polymérisation cationique.

10. Composition de résine photodurcissable pour fabrication additive de l'une quelconque des revendications 1 à 9, qui comporte en outre
(a) un agent de transfert de chaîne ; et/ou
(b) un ou plusieurs additifs choisis dans le groupe constitué par les agents antibulles, les antioxydants, les tensioactifs, les capteurs d'acides, les pigments, les colorants, les épaississants, les ignifugeants, les agents de couplage au silane, les absorbeurs d'ultraviolet, les particules de résine, les modificateurs d'impact à particules coeur-coquille, les polymères solubles et les polymères séquencés.

11. Composition de résine photodurcissable pour fabrication additive de l'une quelconque des revendications 1 à 10, comprenant au moins un photoinitiateur cationique et au moins un photoinitiateur radicalaire, le rapport pondéral entre photoinitiateur cationique et photoinitiateur radicalaire étant inférieur à 4,0.

12. Composition de résine photodurcissable pour fabrication additive de l'une quelconque des revendications 1 à 11, qui comporte en outre un photosensibilisant, de préférence choisi dans le groupe constitué par les méthanones, les xanthénones, les pyrèneméthanols, les anthracènes, les quinones, les xanthones, les thioxanthones, les esters de benzoyle, les benzophénones, et toutes les combinaisons de ceux-ci, mieux encore choisi dans le groupe constitué par la [4-[(4-méthylphényl)thio]phényl]phénylméthanone, l'isopropyl-9*H*-thioxanthén-9-one, le 1-pyrèneméthanol, le 9-(hydroxyméthyl)anthracène, le 9,10-diéthoxyanthracène, l'anthracène, les anthraquinones, la 2-méthylanthraquinone, la 2-éthylanthraquinone, la 2-*tert*-butylanthraquinone, la 1-chloroanthraquinone, la 2-amylanthraquinone, les thioxanthones et les xanthones, l'isopropylthioxanthone, la 2-chlorothioxanthone, la 2,4-diéthylthioxanthone, la 1-chloro-4-propoxythioxanthone, le formate de méthylbenzoyle, le benzoate de méthyl-2-benzoyle, le sulfure de 4-benzoyl-4'-méthyldiphényle, la 4,4'-bis(diéthylamino)benzophénone, et toutes les combinaisons de ceux-ci.

13. Composition de résine photodurcissable pour fabrication additive de l'une quelconque des revendications 1 à 12, la composition de résine photodurcissable étant dépourvue d'initiateur contenant de l'antimoine ou ayant moins de 1,5 % en poids d'initiateur contenant de l'antimoine.

14. Composition de résine photodurcissable pour fabrication additive de l'une quelconque des revendications 1 à 13, comprenant au moins un constituant polymérisable par voie cationique et au moins un constituant polymérisable par voie radicalaire, le rapport pondéral entre constituant polymérisable par voie cationique et constituant polymérisable par voie radicalaire étant inférieur à 7,0.

15. Procédé de fabrication d'un objet tridimensionnel comprenant les étapes consistant à former et durcir sélectivement une couche de la composition de résine photodurcissable pour fabrication additive de l'une quelconque des revendications 1 à 14 par irradiation avec une lumière provenant d'une diode électroluminescente (DEL) ayant une longueur d'onde de 100 nm à 900 nm, de préférence de 340 nm à 415 nm, et répéter les étapes de formation et durcissement sélectif d'une couche de la composition de résine photodurcissable une pluralité de fois pour obtenir un objet tridimensionnel.
